# NEUE EUROPÄISCHE PATENTSCHRIFT

(11) **EP 2 695 502 B2**
(45) Veröffentlichungstag und Bekanntmachung des Hinweises auf die Entscheidung über den Einspruch: **27.07.2022**
(45) Hinweis auf die Patenterteilung: 16.03.2016
(21) Anmeldenummer: 12713713.1
(22) Anmeldetag: 04.04.2012
(51) Int. Cl.: H05K 7/14, H02M 7/00, F03D 9/00, H02J 3/38

(54) **LEISTUNGSSCHALTSCHRANK EINER VORRICHTUNG ZUR ERZEUGUNG ELEKTRISCHER ENERGIE**
POWER SWITCHGEAR CABINET OF A DEVICE FOR PRODUCING ELECTRIC ENERGY
ARMOIRE DE COMMANDE DE PUISSANCE POUR UN DISPOSITIF DE PRODUCTION D'ÉLECTRICITÉ

(30) Priorität: 04.04.2011 DE 102011001786
(43) Veröffentlichungstag der Anmeldung: 12.02.2014
(73) Patentinhaber: ConverterTec Deutschland GmbH, 47906 Kempen (DE)
(72) Erfinder: EICHLER, Markus, 79761 Waldshut-Tiengen (DE); NOWAK, Hans-Georg, 41238 Mönchengladbach (DE); HITPAß, Marianne, 47800 Krefeld (DE)
(74) Vertreter: Cohausz & Florack
(86) Internationale Anmeldenummer: PCT/EP2012/056220
(87) Internationale Veröffentlichungsnummer: WO 2012/136727

(56) Entgegenhaltungen:
- EP-A1- 2 463 996
- EP-A2- 1 802 189
- EP-B1- 1 903 848
- WO-A1-03/065567
- WO-A1-2007/115951
- WO-A1-2010/108928
- WO-A2-2010/089006
- CN-U- 201 742 105
- DE-A1-102006 050 289
- DE-A1-102009 013 311
- US-B2- 7 859 838
- "Frequency Changer", wikipedia,
- "Chopper (electronics", Wikipedia, 1996,
- "List of offshore wind farms", wikipedia, 2016,
- "Schaltschrank", wikipedia, 1982,
- Wikipedia Auszug mit dem Titel "Schaltplan", mit dem letzten Bearbeitungsdatum 12.04.2017
- Handbuch Stromrichter, AEG-Telefunken, ISBN 0-387-08563-7, 29.Auflage, Seiten 81-85/101-102), 178 (siehe https://www.av-huette.de/chronik_buecher.h tml)
- Wikipedia Auszug mit dem Titel "Frequency changer", 04 05 2010
- Wikipedia Auszug mil dem Titel "Chopper (electronics)". Revision as of 27.02.2011
- Hardware Manual ACx 6x7 units, ABB
- Ausdruck einer Suchanfrage im Download Center von ABB fur Frequenzumrichter and Stromumrichter, dem ein Veröffentlichungsdatum der D14 vom 16.5.2003 zu entnehmen ist
- "General considerations for IGBT and intelligent power modules", Mitsubishi Semiconductors Power Modules MOS, die Angabe Sep. 1998 befindet sich im unteren Teil der Seiten
- Fuji IGBT modules application manual, Fuji Electric Device Technology Co.,Ltd ; die Angabe February 2004, REH984 befindet sich auf der ersten Seite
- Ausdruck einer Suchanfrage mittels der "wayback machine", zum Nachweis der Verfügbarkeit der DE16 vor dem Prioritätsdatum des Streitpatents
- Application Note AN-8005, Semikron, issue date 24.09 2008

## Beschreibung

Die Erfindung betrifft einen Leistungsschaltschrank einer Vorrichtung zur Erzeugung elektrischer Energie.

Elektronische Komponenten, wie Umrichter oder Filter, insbesondere von Vorrichtungen zur Erzeugung elektrischer Energie, in Leistungsschaltschränken anzuordnen, ist aus dem Stand der Technik bekannt. Windenergieanlagen werden häufig mit doppelt gespeisten Asynchronmaschinen ausgestattet, da auf diese Weise nur Teilleistungen über die Umrichter der Anlage transportiert werden müssen. Bei Drehzahlen unterhalb der Synchrondrehzahl des Generators sinkt jedoch der Wirkungsgrad der Anlage. Deshalb kommen zunehmend Synchronmaschinen mit Vollumrichter zum Einsatz. Bei diesen Systemen wird jedoch die gesamte an das Netz abzugebende Leistung über einen Umrichter geführt, so dass diese entsprechend dimensioniert und skalierbar aufgebaut sein müssen. Darüber hinaus treten durch die geforderten größeren Leistungen beispielsweise zusätzliche Herausforderungen an eine Kühlung bei gleichzeitig kompakter Bauweise der Schaltschränke auf.

Aber auch bei Systemen mit doppelt gespeisten Asynchronmaschinen, in denen nur ein Teil der Leistung über die Umrichter geführt werden muss, werden immer kompaktere Bauweisen des Schaltschranks oder der Schaltschränke gefordert.

Die Druckschrift EP1903848B1 beschreibt einen modularen Frequenzumrichter, bei welchem der Leistungselektronikteil mit Rädern versehen ist, sowie einen Installationsschrank zum Aufnehmen des Leistungselektronikteils. Um den Leistungselektronikteil mit dem Rest des Frequenzumrichters zu verbinden, sind aufwendige und kostspielige Steckverbindungen notwendig. Zudem wird die elektrische Leistung über ein Kabel zunächst im Installationsschrank nach oben über den Leistungselektronikteil geführt, um von dort wiederum nach unten den Leistungselektronikteil zu versorgen und nach oben den Rest des Frequenzumrichters. Hierdurch entstehen aufwendige Verkabelungen und ein erhöhter Platzbedarf.

Die Druckschrift US 7,859,838 B2 betrifft eine Anordnung zur Platzierung eines Umrichters bzw. Frequenzkonverters in einem Schaltschrank. Der Rahmen des Schaltschranks soll hierbei modular aufgebaut sein, sodass die Komponenten des Frequenzkonverters in den Schaltschrankrahmenmodulen installiert werden können, bevor der Schaltschrank zum Einsatzort gebracht wird. Nachteilig hierbei ist jedoch, dass die einzelnen Komponenten wie Unterbrecher, Sicherungen, Inverter, Brems-Widerstände und Frequenzkonverter auf verschiedene Schränke verteilt werden, was eine weiterhin aufwendige Verkabelung und Kühlung mit mehreren Kühlvorrichtungen erfordert. Nach der Installation in der Fabrik ist eine spätere Skalierbarkeit vor Ort nur mit hohem Aufwand möglich. Zusätzlich benötigen die einzelnen Rahmenmodule vergleichsweise viel Platz.

Der vorliegenden Erfindung liegt somit die technische Aufgabe zugrunde, eine optimale Skalierbarkeit und Kühlung eines Leistungsschaltschranks trotz eines geringen Platzbedarfs zu erzielen.

Die technische Aufgabe wird erfindungsgemäß dadurch gelöst, dass der Leistungsschaltschrank einen maschinenseitigen Anschluss, ein Leistungsmodul und einen netzseitigen Anschluss aufweist, wobei das Leistungsmodul einen maschinenseitigen Umrichter, einen netzseitigen Umrichter, einen Gleichspannungszwischenkreis und einen Chopper aufweist und die Anordnung der Komponenten im Wesentlichen der Richtung des Leistungsflusses entspricht.

Dass die Komponenten im Wesentlichen in der Richtung des Leistungsflusses angeordnet sind, bedeutet, dass die Komponenten in der Reihenfolge, wie Leistung über sie transportiert wird, im Wesentlichen in einer Reihe angeordnet sind. Die Leistung wird hierbei im Falle eines übersynchronen Betriebs einer doppeltgespeisten Asynchronmaschine, bzw. bei Generatorbetrieb einer Synchronmaschine über den maschinenseitigen Anschluss auf einer Seite des Leistungsschaltschranks eingespeist und über den netzseitigen Anschluss auf der gegenüberliegenden Seite wieder abgeführt. Die Komponenten sind also in der Reihenfolge, wie die Leistung über sie transportiert wird, immer weiter von dem Anschluss, über den Leistung eingespeist wird, am einen Ende des Leistungsschaltschranks entfernt angeordnet und immer näher an dem Anschluss, über den Leistung abgeführt wird, am zweiten Ende des Leistungsschaltschranks angeordnet. Der Gleichspannungszwischenkreis mit den Zwischenkreiskondensatoren kann sich hierbei vom maschinenseitigen Umrichter bis zum netzseitigen Umrichter erstrecken.

Durch die Formulierung, dass die Komponenten "im Wesentlichen" in der Richtung des Leistungsflusses angeordnet sein sollen, wird berücksichtigt, dass die einzelnen Komponenten eine gewisse geometrische Ausdehnung aufweisen und durchaus ein geringer Teil einer Komponente mit einer anderen Komponente in Leistungsflussrichtung überlappen kann, solange die eine Komponente größtenteils näher gelegen oder weiter entfernt von einem Ende des Leistungsschaltschranks ist als die andere.

Die Komponenten sind erfindungsgemäß in vertikaler Richtung mit einem Leistungsfluss von oben nach unten oder von unten nach oben angeordnet. Auch eine nicht erfindungsgemäße horizontale Anordnung von links nach rechts, rechts nach links, vorne nach hinten oder hinten nach vorne ist denkbar.

Durch die erfindungsgemäße Anordnung der Komponenten entstehen keine antiparallelen Leistungsflüsse, also keine Schleifen oder kein Hin- und Herführen des Leistungsflusses, was zu einem wesentlich vereinfachten Aufbau des Leistungsschaltschranks mit geringem Platzbedarf führt. Durch die erfindungsgemäße Anordnung der Komponenten in Richtung des Leistungsflusses kann nämlich auch ein Teil des Weges innerhalb des Leistungsschaltschranks durch die Komponenten selbst überbrückt werden, sodass kürzeste Verbindungswege und Verkabelungen erzielt und minimale Verbindungsstrecken zwischen den Komponenten realisiert werden. Gleichzeitig wird eine optimale Skalierbarkeit durch die einfach zugänglichen Leistungsmodule bereitgestellt und zudem durch die kompakte Bauweise einerseits und die Anordnung in Leistungsflussrichtung andererseits die Kühlung der Komponenten vereinfacht.

Das Vorsehen dieser erfindungsgemäßen Komponenten in dem Leistungsschaltschrank und deren Zusammenwirken erlaubt eine optimale Skalierbarkeit einer Vorrichtung zur Erzeugung elektrischer Energie. Es werden nämlich im Wesentlichen eigenständige Leistungsschaltschränke zur Verfügung gestellt, mit denen auf einfachste Weise mittels Anpassen der Anzahl der Leistungsschaltschränke oder durch eine Anpassung von Typ und/oder Anzahl der elektronischen Leistungsschalter die Leistung skaliert werden kann.

Aufgrund der im Leistungsschaltschrank vorgesehenen maschinen- und netzseitigen Anschlüsse, dem Leistungsmodul, welches neben den netzseitigen und maschinenseitigen Umrichtern auch einen Chopper zum Kurzschließen des jeweiligen Zwischenkreises aufweist, wird es ermöglicht, die Komponenten so anzuordnen, dass nur minimale Verbindungswege zwischen den einzelnen Komponenten entstehen. Diese kurzen Verbindungswege führen einerseits zu einer hohen Leistungsdichte und somit zu einer sehr kompakten Anordnung und andererseits dadurch auch zu Kosteneinsparungen. Die Auswahl der Komponenten, welche die Leistungsschaltschränke aufweisen, ermöglicht des Weiteren, einen optimalen Leistungsfluss zu erzielen, denn es sind außer den maschinenseitigen und netzseitigen Anschlüssen keine Querverbindungen zu anderen optionalen Leistungsschaltschränken notwendig, was komplizierte Kreuzungen von Kabelwegen zur Folge hätte.

Der maschinenseitige Anschluss des Leistungsschaltschranks wird bzw. die maschinenseitigen Anschlüsse der mindestens zwei Leistungsschaltschränke werden, vorzugsweise über weitere Komponenten, wie Schalter oder auch einen Generatoranschlussschrank, welcher Schalter und/oder Schutzelemente aufweisen kann, an eine elektrische Maschine, beispielsweise einen Generator oder einen Motor angeschlossen. Ist mehr als ein Leistungsschaltschrank vorgesehen, werden die mindestens zwei Leistungsschaltschränke hierbei parallel geschaltet. Der maschinenseitige Anschluss ist vorzugsweise als Anschlussschiene ausgebildet, jedoch sind auch andere Verbindungen, wie Kabelverbindungen, denkbar. Anschlussschienen sind mechanisch robust und stellen auf einfache Weise die notwendigen Querschnitte zur Verfügung, um hohe Leistungen zu transportieren. Darüber hinaus lassen sie eine einfache, ebenfalls große Querschnitte aufweisende Verbindung zwischen zwei Anschlussschienen zu. Auch netzseitig können Anschlussschienen, insbesondere zur Parallelschaltung der Leistungsschaltschränke, verwendet werden.

Der maschinenseitige und der netzseitige Umrichter des Leistungsmoduls weist vorzugsweise elektronische Leistungsschalter auf, um Wechselstrom in Gleichstrom umzuwandeln oder andersherum. Diese elektronischen Schalter können beispielsweise Dioden, Transistoren, Integrated-Gate-Commutated-Thyristoren (IGCT) oder vorzugsweise Insulated-Gate-Bipolar-Transistoren (IGBT) sein. Letztere erlauben eine nahezu leistungslose Ansteuerung bei überdurchschnittlicher Robustheit und eine kompakte Bauweise. Diese elektronischen Leistungsschalter sind insbesondere so ausgebildet, dass sie einzeln oder als Modul zu mehreren elektronischen Leistungsschaltern in oder auf das Leistungsmodul montiert werden können.

Die energetische Verkopplung der beiden durch den Umrichter elektrisch verbundenen Stromnetze auf einer gemeinsamen Gleichspannungsebene wird vorzugsweise durch Kondensatoren erzielt, welche den Gleichspannungszwischenkreis bilden.

Das Vorsehen eines Choppers ermöglicht es, mittels eines elektronischen Leistungsschalters elektrische Energie über einen sogenannten Bremswiderstand in Wärmeenergie umzuwandeln und abzuführen. Als elektronischer Leistungsschalter kommt insbesondere wieder ein IGBT in Betracht, andere elektronische Leistungsschalter sind jedoch auch möglich. Das Vorsehen eines Choppers in jedem Leistungsschaltschrank ist besonders vorteilhaft, da somit in jedem Gleichspannungszwischenkreis Energie abgeführt werden kann. Die Chopper können daher an die jeweilige Leistung des einzelnen Schaltschranks angepasst sein. Bei einer Erweiterung der Vorrichtung fällt zudem eine neue Dimensionierung des Choppers, wie sie bei parallel geschalteten Gleichspannungszwischenkreisen notwendig wäre, weg. Zudem fallen Sicherungsmaßnahmen aufgrund der begrenzten über den Chopper abzuführenden Energie weg. Es ist allerdings besonders vorteilhaft, wenn der Chopper zwischen dem netzseitigen und dem maschinenseitigen Umrichter auf einer die Kondensatoren des Gleichspannungszwischenkreises aufweisender Gleichstromverschienung angeordnet ist.
Hierdurch wird eine besonders kurze, symmetrische und unmittelbare Anbindung an den Gleichspannungszwischenkreis erreicht, was sich positiv auf die Kompaktheit der Leistungsschaltschränke auswirkt und eine gleichmäßige thermische Belastung der Kondensatoren ermöglicht. Des Weiteren ist es möglich, den elektronischen Leistungsschalter und den Widerstand des Choppers als gemeinsame Einheit zu montieren, oder aber auch, falls die Bauart des Widerstandes dies nicht zulässt, den Widerstand räumlich getrennt vom Leistungsschalter zu montieren.

Bei der Verwendung einer Gleichstromverschienung kann einfach über zwei Leiterebenen mit einer dazwischen liegenden Isolierung der Gleichspannungszwischenkreis mit sehr niedriger Induktivität realisiert werden. Dies führt zu einer besonders kompakten Bauweise des Leistungsmoduls. Für Drei-Level-Umrichter kann entsprechend eine dritte Gleichstromleiterebene in der Gleichstromverschienung vorgesehen sein, so dass ohne Änderung des mechanischen Aufbaus der Leistungsschaltschränke eine Schaltschrankanordnung für den Niederspannungs- als auch für den Mittelspannungsbetrieb zur Verfügung gestellt werden kann.

Das Leistungsmodul mit netzseitigem Umrichter, Gleichspannungszwischenkreis, Chopper und maschinenseitigem Umrichter ist über die beiden Umrichter vorzugsweise über Kupferschienen mit den netz- und/oder maschinenseitigen Anschlüssen des Schaltschranks verbunden. Allerdings können auch weitere Komponenten zwischen Leistungsmodul und netz- und maschinenseitigen Anschlüssen vorhanden sein, welche ebenfalls über Kupferschienen an das Leistungsmodul angebunden sind. Kupferschienen ermöglichen eine besonders verlustarme elektrische Verbindung. Allerdings ist es auch denkbar, entsprechend verlustarm ausgebildete Kabelverbindungen vorzusehen.

Hierdurch wird ein weitestgehend modularer Aufbau der Leistungsschaltschrankkomponenten erzielt, sodass der Austausch von einzelnen defekten Komponenten ohne zusätzliche Hilfsmittel durchgeführt werden kann.

Ein Leistungsschaltschrank ist vorzugsweise für Leistungen von typischerweise bis zu 1 MW ausgelegt, wobei sowohl Niederspannung bis zu 1 kV als auch Mittelspannungen von bis zu 30kV verwendet werden können. Es sind selbstverständlich aber auch größere Leistungen pro Leistungsschaltschrank denkbar. Eine Skalierung der Leistung der Leistungsschaltschränke kann beispielsweise einerseits durch eine Anpassung von Typ und/oder Anzahl der elektronischen Leistungsschalter erfolgen und/oder andererseits besonders einfach durch das Vorsehen einer unterschiedlichen Anzahl von erfindungsgemäßen Leistungsschaltschränken.

Insgesamt lässt sich durch einen erfindungsgemäßen Schaltschrank nicht nur eine optimale Skalierbarkeit und Kühlung des Leistungsschaltschranks trotz eines geringen Platzbedarfs erzielen, sondern auch ein kostensparender Aufbau mit minimalen Verbindungsstrecken zwischen den Komponenten und dadurch mit einem optimalen Leistungsfluss und hoher Leistungsdichte realisieren.

Gemäß einer Ausgestaltung des erfindungsgemäßen Schaltschranks, weist der Leistungsschaltschrank eine dezentrale Steuerungseinheit auf. Das Vorsehen einer dezentralen Steuerungseinheit ermöglicht eine Optimierung der Flexibilität in Bezug auf die Installation der Leistungsschaltschränke und der Skalierbarkeit, insbesondere wenn mehr als ein Leistungsschaltschrank vorgesehen ist. Die einzelnen Komponenten eines Leistungsschaltschranks müssen nicht einzeln angesteuert werden, sondern können alle intern von der dezentralen Steuerungseinheit angesprochen werden.
Diese kann bevorzugt mit allen relevanten implementierten Komponenten, also allen Aktoren und Sensoren des Leistungsschaltschranks kommunizieren, insbesondere jedoch mit dem Leistungsmodul. Auch Temperatur-oder Feuchtigkeitssensoren zur Überwachung können ausgelesen oder überwacht werden. Aufgrund der kurzen Signalwege erlaubt eine dezentrale Steuereinrichtung die Verwendung einfacher elektrischer Datenverbindungen beispielsweise zu den Treibern der IGBT's und anderen Sensoren und Aktoren. Bei langen Signalwegen kommt lediglich die Verwendung von Lichtwellenleiter aufgrund der starken elektromagnetischen Störungssignale in Frage. Dies hat zur Folge, dass die optischen Signale häufig wieder in elektrische Signale umgewandelt werden müssen. Die Kommunikation mit den in dem Leistungsschaltschrank vorgesehen Komponenten wird demnach deutlich vereinfacht. Die dezentralen Steuerungseinheiten können über einfache Datenverbindungen mit einer zentralen Steuerungseinheit verbunden werden. Die Anzahl der nötigen Verbindungen und Verkabelungen wird also auf ein Minimum reduziert. Vorzugsweise sind die dezentralen Steuerungseinheiten so ausgebildet, dass diese über eine Verbindung über einen Lichtwellenleiter beispielsweise mit einer zentralen Steuereinheit, kommunizieren können. Die dezentralen Steuerungseinheiten können dann beispielsweise mit weiteren Systemen, wie weiteren Steuerungseinheiten, kommunizieren. Hierbei kann sowohl eine Stern, Ring-, Reihen- und/oder Bustopologie der dezentralen Steuerungseinheiten vorgesehen sein.

Der erfindungsgemäß Leistungsschaltschranks ist dadurch gekennzeichnet, dass die Komponenten im Wesentlichen linear in der Reihenfolge maschinenseitiger Anschluss, maschinenseitiger Umrichter, Gleichspannungszwischenkreis mit Chopper, netzseitiger Umrichter und netzseitiger Anschluss angeordnet sind. Hierbei sind die Komponenten auf einer zwischen dem maschinenseitigen Anschluss und dem netzseitigen Anschluss gedachten, im Wesentlichen geraden Linie in der Reihenfolge angeordnet, wie Leistung durch sie transportiert wird, also in der Reihenfolge maschinenseitiger Anschluss, maschinenseitiger Umrichter, Gleichspannungszwischenkreis mit Chopper, netzseitiger Umrichter, netzseitigen Anschluss. Hierdurch wird eine besonders einfache, kompakte und übersichtliche Schaltschrankeinrichtung mit minimalen Verbindungswegen zwischen den Komponenten ermöglicht. Auch die Strömung eventueller Lüftkühlungen wird hierdurch besonders effizient durch den Schaltschrank geführt.

Auf Grund einer möglichst einfachen Zugänglichkeit und thermischer Effekte ist eine im Wesentlichen vertikale Anordnung der Komponenten erfindungsgemäß vorgesehen, wobei die Anordnung der Komponenten sowohl von oben nach unten als auch von unten nach oben entsprechend der genannten Reihenfolge erfolgen kann. In Hinblick auf thermische Effekte und eine effiziente Kühlung hat sich allerdings eine vertikale und lineare Anordnung von oben nach unten als besonders vorteilhaft herausgestellt.

Ist mehr als ein erfindungsgemäßer Leistungsschaltschrank, beispielsweise in einer Schaltschrankanordnung, vorgesehen, können die Leistungsschaltschränke über den netzseitigen Anschluss und optional über den maschinenseitigen Anschluss elektrisch parallel miteinander verbunden sein. Die maschinenseitigen Anschlüsse können elektrisch parallel miteinander verbunden und dann mit der Wicklung der Maschine verbunden werden. Bei Verwendung einer Maschine mit getrennten Wicklungen ist es auch denkbar, dass die maschinenseitigen Anschlüsse elektrisch getrennt mit den jeweiligen Wicklungen verbunden werden.

Sind alternativ zum netzseitigen parallelen Anschluss der Leistungsschaltschränke die Leistungsschaltschränke jeweils einzeln über zugeordnete Sekundärwicklungen eines oder mehrerer Transformatoren an das Netz angebunden, kann verhindert werden, dass sich Kreisströme zwischen mehreren sowohl maschinen- als auch netzseitig parallel verbundenen Leistungsschaltschränken ausbilden. Es können Transformatoren mit je einer Primär- und einer Sekundärwicklung verwendet werden oder auch ein Transformator mit je einer Primär- und mehreren Sekundärwicklungen.

Gemäß einer weiteren Ausgestaltung des erfindungsgemäßen Leistungsschaltschranks weist das Leistungsmodul eine plattenförmige Gleichstromverschienung auf, welche auf einer ersten Seite die Leistungsschalter und einen Chopper aufweist und auf einer zweiten Seite die Kondensatoren des Gleichspannungszwischenkreises aufweist.

Durch die Gleichstromverschienung und die Anbindung der Leistungsschalter und des Choppers auf der einen Seite und der Kondensatoren des Gleichspannungszwischenkreise auf der anderen Seite der Gleichstromverschienung kann eine sehr platzsparende Anordnung der Leistungsmodule, welche dem entsprechend eine hohe Leistungsdichte aufweisen, erreicht werden. Hierdurch wird auch ein einfacher Zugriff und somit eine einfache Installation und eine einfache Wartung der elektronischen Leistungsschalter ermöglicht.

Die Kondensatoren können insbesondere über Anschlusselemente eines ersten Rastermaßes leitend mit der Gleichstromverschienung verbunden werden, während der mindestens eine elektronische Leistungsschalter über Anschlusselemente eines zweiten Rastermaßes leitend mit der Gleichstromverschienung verbunden ist.

Das zweite Rastermaß der Gleichstromverschienung ermöglicht den variablen Anschluss von einem aber auch von mehreren elektronischen Leistungsschaltern an die Gleichstromverschienung, so dass eine einfache Skalierbarkeit der Schaltungsanordnung gegeben ist. Anschlusselemente werden vorzugsweise durch Kontaktlöcher in der jeweiligen Metallplatte des elektrischen Anschlusspols der Gleichstromverschienung gebildet, so dass die einzelnen Kondensatoren und elektronischen Leistungsschalter elektrisch leitend mit der Gleichstromverschienung verbunden werden können. Das erste Rastermaß und das zweite Rastermaß können entweder identisch oder voneinander verschieden ausgebildet sein. Der Platzbedarf wird hierdurch weiter verringert und darüber hinaus die Skalierbarkeit vereinfacht.

Vorzugsweise ist eine Mehrzahl parallel geschalteter Kondensatoren, vorzugsweise eine Kondensatorbank vorgesehen, wobei die einzelnen Kondensatoren über die im ersten Rastermaß angeordneten Anschlusselemente mit der Gleichstromverschienung elektrisch leitend verbunden sind. Das erste Rastermaß der Gleichstromverschienung ermöglicht eine besonders kompakte Anordnung der Kondensatoren, da das Rastermaß beispielsweise auf die Größe und den Raumbedarf der Kondensatoren abgestimmt werden kann.

Bevorzugt sind die im zweiten Rastermaß angeordneten Anschlusselemente der Gleichstromverschienung derart ausgebildet, dass eine Mehrzahl an elektronischen Leistungsschaltern in achsensymmetrischer Anordnung mit der Gleichstromverschienung elektrisch leitend verbunden werden kann. Für die im zweiten Rastermaß angeordneten Anschlusselemente bedeutet dies, dass die elektrischen Anschlusspole beispielweise die Kontaktierung eines um 180 Grad gedrehten elektronischen Leistungsschalters ermöglicht. Die achsensymmetrische Anordnung von elektronischen Leistungsschaltern ermöglicht einen symmetrischen Aufbau der Schaltungsanordnung und insofern eine weitere Reduzierung des Raumbedarfs des Leistungsmoduls und somit des gesamten Leistungsschaltschranks.

Durch das Vorsehen einer Adapterverschienung, welche auf einer Anschlussseite an den elektronischen Leistungsschalter angepasst ist und auf der anderen Seite an das zweite Rastermaß angepasst ist, können elektronische Leistungsschalter unterschiedlicher Hersteller und/oder unterschiedlicher Typen eingesetzt werden.

Es können natürlich auch mehrere elektrisch miteinander verbundene Gleichstromverschienungen innerhalb eines Leistungsschaltschranks vorgesehen sein, um eine Skalierbarkeit innerhalb eines Leistungsschaltschranks zu erreichen. Diese können über kurze Kupferschienen, Kabel oder weitere Verschienungen seitlich in Reihe oder Rücken an Rücken verbunden werden.

Der Chopper kann entweder direkt mit der Gleichstromverschienung elektrisch verbunden sein oder über eine spezifische Adapterverschienung an die Gleichstromverschienung angeschlossen sein. Wird der Chopper direkt mit der Gleichstromverschienung verbunden, werden einerseits die Kosten für eine Adapterverschienung eingespart. Die Adapterverschienung kann aber dazu verwendet werden, um den Chopper anwendungsspezifisch an einer geeigneten Stelle der Schaltungsanordnung anzuordnen, ohne die Gleichstromverschienung verändern zu müssen. Durch die direkte Anbindung des Choppers an die Gleichstromverschienung werden sehr geringe Streuinduktivitäten erreicht und eine gleichmäßige Aufteilung der Ströme durch die Gleichstromverschienung und der an der Gleichstromverschienung angeschlossenen Kondensatoren. Hierdurch wird eine gleichmäßige Wärmeverteilung erreicht, was wiederum einen kompakteren und besser zu kühlenden Leistungsschaltschrank ermöglicht. Vorzugsweise ist der Chopper zwischen den elektronischen Leistungsschaltern des netzseitigen Umrichters und des maschinenseitigen Umrichters auf einer Seite der Gleichstromverschienung angeordnet.

Gemäß einer weiteren Ausgestaltung des erfindungsgemäßen Leistungsschaltschranks, weist der Leistungsschaltschrank einen dU/dt-Filter auf. Sind mehrere Leistungsschaltschränke vorgesehen, weisen bevorzugt die Leistungsschaltschränke jeweils einen dU/dt-Filter auf. Dieser ermöglicht eine Begrenzung von Spannungssteilheiten. Der dU/dt-Filter ist insbesondere dem maschinenseitigen Anschluss vorgeschaltet, also zwischen dem maschinenseitigen Umrichter und dem maschinenseitigen Anschluss angeordnet, und schützt die Maschine vor zu schnellen Spannungsänderungen. Indem die Leistungsschaltschränke einen dU/dt-Filter aufweisen, werden außerdem weitere Verkabelungen aus dem Leistungsschaltschrank heraus vermieden. Ein dU/dt-Filter weist insbesondere eine Drossel und optional eine RC-Beschaltung auf. Der dU/dt-Filter kann über Schienen, wie Kupferschienen, Kabel oder Litze eingebunden werden. Dadurch bleibt die Modularität der Komponenten erhalten und eine vereinfachte Wartung kann erreicht werden. Ein Sensor zur Überwachung der Temperatur des dU/dt-Filter kann optional mit der dezentralen Steuerungseinheit kommunizieren.

Vorzugsweise weist der Leistungsschaltschrank eine Netzdrossel auf. Diese dient der Entkopplung vom Netz. Die Netzdrossel kann ebenfalls über Schienen, wie Kupferschienen, Kabel oder Litze eingebunden werden. Dadurch bleibt die Modularität der Komponenten erhalten und eine vereinfachte Wartung kann erreicht werden. Insbesondere durch Litzenanschlüsse kann eine flexible Verbindung an einen Umrichter erreicht werden, was eine schnelle Montage oder auch die Verwendung von Netzdrosseln verschiedener Hersteller ermöglicht. Ein Sensor zur Überwachung der Temperatur der Netzdrossel kann auch mit der dezentralen Steuerungseinheit kommunizieren. Bei einer Anordnung der Komponenten in Reihe ist die Netzdrossel bevorzugt zwischen netzseitigem Anschluss und Leistungsmodul oder, falls eine Kühlvorrichtung vorhanden ist, zwischen netzseitigem Anschluss und dem der Kühlvorrichtung angeordnet. Besonders bevorzugt ist aufgrund von thermischen Effekten zur effektiveren Kühlung eine im Wesentlichen vertikale Anordnung, wobei die Netzdrossel unterhalb des Leistungsmoduls bzw. der Kühlvorrichtung angeordnet ist.

Es ist weiterhin bevorzugt, wenn der Leistungsschaltschrank an den netzseitigen Anschlüssen und/oder den maschinenseitigen Anschlüssen vorgeschaltete, also zwischen den netz- oder maschinenseitigen Umrichtern und den netz- oder maschinenseitigen Anschlüssen angeordnete, Trenneinrichtungen zum elektrischen Trennen des Leistungsschaltschranks, beispielsweise elektrische Trenneinrichtungen wie Schütze, IGBTs oder ICTs oder auch mechanische Trenneinrichtungen wie Schalter oder Leistungstrenner aufweist. Dies ermöglicht eine weitere Vereinfachung von Wartungsarbeiten, da auf diese Weise einzelne Leistungsschaltschränke netzseitig und/oder maschinenseitig vom Netz getrennt werden können. Die Schütze können beispielsweise über kurze Kupferverbindungen mit dem jeweiligen Anschluss elektrisch verbunden sein.

Ist mehr als ein Leistungsschaltschrank in einer Schaltschrankanordnung vorgesehen und weist eine Schaltschrankanordnung beispielsweise zumindest teilweise redundante Leistungsschaltschränke auf, können diese selbst während des Betriebs ab- oder zugeschaltet werden. Eine Wartung oder ein Austausch von defekten Komponenten ist somit schnell und einfach durchzuführen. Zudem wird beispielsweise der Wirkungsgrad erhöht, wenn der Generator unterschiedliche Leistungen abgibt und bei geringeren Leistungen Leistungsschaltschränke abgeschaltet werden können. Des Weiteren kann bei einem Defekt in einem der Leistungsschaltschränke dieser elektrisch von den anderen getrennt werden. Somit kann das Gesamtsystem mit reduzierter Kapazität weiterbetrieben werden und Energie in das Netz einspeisen. Dies ist insbesondere für Offshore-Windenergieanlagen von Bedeutung, da diese nur unter erschwerten Bedingungen zu erreichen sind.

Weist der Leistungsschaltschrank neben dem Chopper eine weitere Strom- und/oder Spannungsbegrenzungsvorrichtung auf, können sensible Bereich des Leistungsschaltschranks vor zu hohen Strömen und/oder Spannungen geschützt werden. Die Strom- und/oder Spannungsbegrenzungsvorrichtung kann insbesondere maschinenseitig vorgesehen sein, beispielsweise im Bereich des maschinenseitigen Anschlusses, um den maschinenseitigen Umrichter sowie den Gleichspannungszwischenkreis zu schützen. Hierfür kann beispielsweise eine sogenannte "Crowbar" vorgesehen sein. Verschiedene Ausführungen einer solchen Crowbar sind aus dem einschlägigen Stand der Technik bekannt. In Abhängigkeit beispielsweise einer bestimmten Spannung im Gleichspannungszwischenkreis oder eines bestimmten Stromes zwischen Generator und maschinenseitigem Umrichter wird die Crowbar aktiviert und schließt die maschinenseitigen Anschlüsse kurz. Somit kann kein Strom mehr vom Generator in den maschinenseitigen Umrichter fließen, wodurch auch eine Erhöhung der Spannung im Gleichspannungszwischenkreis ausgeschlossen ist.

Gemäß einer nächsten Ausgestaltung des erfindungsgemäßen Leistungsschaltschranks weist dieser eine Notspannungsversorgung auf. Damit kann insbesondere die Stromversorgung der Steuerungselektronik für eine gewisse Zeit aufrecht erhalten werden, um beispielsweise ein kontrolliertes Abschalten der Leistungsschaltschränke oder der Vorrichtung zur Erzeugung elektrischer Energie zu ermöglichen. Ist eine dezentrale Steuerungseinheit vorgesehen, kann insbesondere diese mit der Notspannung versorgt werden. Benötigte Steuerungselektronik kann dann über die dezentrale Steuerungseinheit versorgt werden.

Solch eine unterbrechungsfreie Stromversorgung (USV) kann durch zusätzliche innerhalb oder außerhalb des Leistungsschaltschranks angeordnete Geräte sichergestellt werden. Nachteilig ist allerdings, dass innerhalb des Leistungsschaltschranks Akkumulatoren oder Batterien häufig unerwünscht sind, da diese unter anderem viel Platz einnehmen. Sind solche USV-Geräte außerhalb des Leistungsschaltschranks angeordnet ist unter Umständen eine aufwendige Verkabelung aus dem bzw. in den Leistungsschaltschrank nötig. Weiterhin können auch die USV-Geräte ausfallen.

Daher ist es besonders vorteilhaft, wenn die Notspannungsversorgung den Gleichspannungszwischenkreis als Spannungsquelle verwendet. Im Generatorbetrieb wird im Leistungsschaltschrank über den Gleichspannungszwischenkreis kontinuierlich Energie vom maschinenseitigen Umrichter zum netzseitigen Umrichter transportiert. Daher kann durch den Gleichspannungszwischenkreis ein Energiespeicher bereitgestellt werden, welcher im Notfall benötigte Steuerungselektronik zeitlich begrenzt mit Energie versorgen kann. Die Energiequelle der Notspannungsversorgung kann über Spannungswandler mit der zu versorgenden Elektronik verbunden sein. Im normalen Betriebsfall erfolgt die Spannungsversorgung der Steuerungselektronik über die dafür vorgesehene Hilfsspannungsversorgung. Nur für den Fall, dass diese keine ausreichende Spannung mehr liefern kann, erfolgt die Spannungsversorgung der vorgenannten Bauteile über die durch den Gleichspannungszwischenkreis gespeiste Notspannungsversorgung. Um eine aufwendige Umschaltung zu vermeiden, können die beiden Spannungsversorgungen vorteilhaft über Dioden voneinander entkoppelt werden.

Gemäß einer weiteren Ausgestaltung des erfindungsgemäßen Leistungsschaltschranks weist der Leistungsschaltschrank eine Kühlvorrichtung auf, insbesondere einen Wärmetauscher. Die Kühlung kann sowohl über Lüftkühlung, beispielsweise mittels Lüfter, als auch über einen Wärmetauscher erfolgen. Der Wärmetauscher verwendet vorzugsweise ein Kühlmittel, insbesondere Wasser. Als Kühlmittel kann vorteilhaft auch ein Wasser-Glykol-Gemisch zum Einsatz kommen, es ist aber auch jedes andere flüssige Kühlmedium denkbar. Vorzugsweise werden aber beide Verfahren gleichzeitig genutzt, so dass ein entsprechend kompakter Aufbau realisiert werden kann. Komponenten, welche beispielsweise eine Wasserkühlung erlauben, dies sind im Allgemeinen die elektronischen Leistungsschalter der Wechselrichter und des Choppers, die dU/dt-Filter und die Netzdrossel, werden an einen Wasserkühlkreislauf angeschlossen. Bei anderen Komponenten wie beispielsweise den Zwischenkreiskondensatoren ist eine Luftkühlung vorteilhaft.

Gemäß einer weiteren Ausgestaltung des erfindungsgemäßen Leistungsschaltschranks weist die Kühlvorrichtung eine "Heat-Pipe" auf. Unter einer "Heat Pipe" wird ein Wärmeüberträger verstanden, welcher mittels Verdampfungswärme eines im Wärmerohr vorgesehenen Transportmediums hohe Wärmestromdichten erzielt. Das Wärmerohr kann dazu genutzt werden, Wärme von einzelnen Komponenten abzuführen, Wärme innerhalb des Leistungsschaltschranks zu transportieren und/oder Wärme aus dem Leistungsschaltschrank hinaus, beispielsweise aus einem im Leistungsschaltschrank vorgesehenem Kühlsystem, zu führen. Hierbei kann das Transportmedium sowohl mittels Schwerkraft als auch mittels Kapillareffekten transportiert werden.

Weist die Kühlvorrichtung zumindest einen direkt unterhalb der Kondensatoren des Gleichspannungszwischenkreises angeordneten Lüfter auf, so kann eine weiterhin optimierte Kühlung des Leistungsschaltschranks in Kombination mit der erfindungsgemäßen Anordnung der Komponenten erreicht werden. Dabei erzeugt der Lüfter einen Luftstrom, welcher ein Stauen von warmer Luft an den Kondensatoren unterbindet. Ist der Lüfter gleichzeitig an einem unterhalb des Lüfters angeordneten Luft-Wasser-Wärmetauscher angeschlossen, kann gleichzeitig die Wärme des Luft-Wasser-Wärmetauschers abgeführt werden. Die Kondensatoren des Gleichspannungszwischenkreises des Leistungsmoduls und der mindestens eine Lüfter sind dabei im hinteren Teil des Leistungsschaltschranks angeordnet, während die Leistungsschalter des Leistungsmoduls von vorne einfach zugänglich sind. So wird bei gleichzeitig kompakter Anordnung der Komponenten eine ausreichende Kühlung erzielt und eine Skalierbarkeit des Leistungsschaltschranks weiterhin gewährleistet.

Eine Kühlung innerhalb eines Leistungsschaltschranks kann die Lebensdauer insbesondere in klimatisch ungünstigen Regionen der Komponenten erhöhen, da ein hermetischer Aufbau des Leistungsschaltschranks ermöglicht und eine Kontamination der Komponenten mit feuchter, salzhaltiger oder schmutziger Luft von außen vermieden wird. Bevorzugt werden das Leistungsmodul, also insbesondere der maschinenseitige und netzseitige Umrichter sowie der Chopper, die Netzdrossel und/oder der dU/dt-Filter wassergekühlt. Optional können auch an den netz- und maschinenseitig Anschlüssen vorgesehene Schütze luft- oder wassergekühlt werden.

In einem Wasserkühlkreislauf kann außerdem eine Vorheizeinrichtung vorgesehen sein, sodass bei sehr tiefen Umgebungstemperaturen das Leistungsmodul, insbesondere die elektronischen Leistungsschalter, einerseits auf Betriebstemperatur vorgewärmt werden kann und andererseits nach dem Betrieb Kondensation an diesen Komponenten vermieden werden kann.

Vorzugsweise ist der Leistungsschaltschrank gemäß einer weiteren Ausgestaltung hermetisch gegenüber der Umgebungsluft abgeschlossen. Vorteilhaft ist in diesem Fall der Einsatz von Wärmetauschern, insbesondere ein Luft-Wasser-Wärmetauscher, welcher die Abwärme der Bauteile dem Wasserkühlkreislauf zuführt, so dass eine Zufuhr von kühlender Außenluft nicht notwendig ist. Durch die Verwendung von Wärmetauschern wird auch ohne Zuluft eine ausreichende Kühlung der Komponenten in den Leistungsschaltschränken sichergestellt. Ist mehr als ein Leistungsschaltschrank vorgesehen, können die Kühlkreisläufe der Leistungsschaltschränke zusammengeschaltet oder auch unabhängig voneinander betrieben werden. Aufgrund der unterschiedlichen Wärmeentwicklung der einzelnen Komponenten ist es besonderes vorteilhaft, wenn die einzelnen Komponenten im Wesentlichen einer vertikalen Anordnung folgen. In diesem Fall kann entstehende Wärme durch die natürliche Konvektion abtransportiert werden. Die Kühlvorrichtung ist vorzugsweise unterhalb des Leistungsmoduls angeordnet, so dass die natürliche Konvektion unterstützt werden kann. Bei einem Wasser-Luft-Wärmetauscher wird hierbei eine optimale Kühlluftzirkulation erreicht, welche das Leistungsmodul, insbesondere die Kondensatoren des Gleichspannungszwischenkreises kühlen.

Ist mehr als ein Leistungsschrank vorgesehen, sind die Leistungsschaltschränke vorzugsweise mittels AC-Schienen parallel geschaltet. Hierdurch kann eine einfach zu montierende, und gleichzeitig stabile Parallelschaltung von einzelnen Leistungsschaltschränken realisiert werden. Die AC-Schienen sind aufgrund der Leitfähigkeit vorzugsweise aus Kupfer. Im Falle von Dreiphasenwechselstrom sind bei einem Leistungsschaltschrank mindestens dreipolige Schienen vorzusehen. Die AC-Schienen können so angeordnet werden, dass die Verbindung zu anderen optionalen Leistungsschaltschränken seitlich, rückwärtig und/oder nach oben möglich ist. Die Vorderseite der Leistungsschaltschränke dient vorzugsweise für einen einfachen Montage- und Wartungszugriff.

Grundsätzlich sind aber auch Kabel und/oder Litzen zur Verbindung der Leistungsschaltschränke denkbar.

Ist mehr als ein Leistungsschrank vorgesehen, sind die Leistungsschaltschränke bevorzugt seitlich in Reihe und/oder Rücken an Rücken angeordnet. Auf diese Weise kann eine einfache Leistungsanpassung trotz einer kompakten Anordnung der Leistungsschaltschränke erzielt werden.

Der Leistungsschaltschrank kann in einer Schaltschrankanordnung mit einem Netzanschlussschaltschrank kombiniert werden, welcher eine zentrale Steuerungseinheit aufweist. Über die zentrale Steuerungseinheit können die dezentralen Steuerungseinheiten des einen oder der mehreren Leistungsschaltschränke gesteuert werden. Wird eine Verbindung zwischen den dezentralen Steuerungseinheiten und der zentralen Steuerungseinheit hergestellt, kann über die Verbindung auf einfache Weise jede Komponente der Leistungsschaltschränke angesprochen werden. Soll beispielsweise die Schaltschrankanordnung um einen weiteren Leistungsschaltschrank erweitert werden, muss lediglich der netzseitige und maschinenseitige Anschluss elektrisch verbunden werden und die dezentrale Steuerungseinheit sowie die Hilfsspannungsversorgung angeschlossen werden. Die Anzahl der nötigen Verbindungen und Verkabelungen wird also auf ein Minimum reduziert. Hierbei keine sowohl eine Stern, Ring-, Reihen- und/oder Bustopologie der dezentralen Steuerungseinheiten vorgesehen sein. Die Verwendung eines separaten Netzanschlussschaltschrankes verbessert zudem die Skalierbarkeit der Schaltschrankanordnung, da dieser bei Leistungsanpassungen ausgetauscht bzw. getrennt von den Leistungsschaltschränken angepasst werden kann.

Die zentrale Steuerungseinheit kann aber auch so ausgebildet sein, dass sie mit weiteren Systemen kommunizieren kann. So können verschiedene Schnittstellen und Busse, wie Ethernet, CANOpen oder andere digitale oder analoge Ein- und Ausgänge vorgesehen sein, um beispielsweise Daten des Generators oder des Rotors ebenfalls berücksichtigen oder beeinflussen zu können.

Der Netzanschlussschrank dient des Weiteren der Verbindung des einen oder der mehreren Leistungsschaltschränke mit dem Netz.

Vorzugsweise weist der Netzanschlussschaltschrank einen oder mehrere Netzfilter auf. Dieser dient einer Begrenzung von elektrischen Störungen sowohl in das Netz als auch aus dem Netz. Ein solcher Netzfilter kann aus Induktivitäten, Kondensatoren und/oder Widerständen aufgebaut sein. Dadurch, dass der Netzfilter in dem Netzanschlussschrank vorgesehen ist, ist er allen Leistungsschaltschränken vorgeschaltet und es muss nur ein einziger Filter vorgesehen werden. Es ist grundsätzlich aber auch denkbar, Netzfilter jeweils in den Leistungsschaltschrank oder die Leistungsschaltschränke zu integrieren.

Der Netzanschlussschaltschrank weist bevorzugt eine Hilfsspannungsversorgung und/oder einen Netzschalter auf. Die Hilfsspannungsversorgung erzeugt aus dem netzseitigen Wechselstrom vorzugsweise eine einphasige 230 V Wechselspannung. Es sind jedoch beliebige Gleich- und/oder Wechselspannungen denkbar. Ebenso ist es möglich, die Hilfsspannung von extern einzuspeisen, so dass in diesem Fall die Hilfsspannungsversorgung im Netzanschlussschrank lediglich als Verteilknoten für die Leistungsschaltschränke dient. Die Hilfsspannungsversorgung kann so auf einfache

Weise für alle Leistungsschaltschränke bereitgestellt werden. Über einen oder mehrere Netzschalter können alle Leistungsschaltschränke auf einfach Weise vom Netz getrennt werden.

Vorzugsweise sind die zentrale Steuerungseinheit und die dezentralen Steuerungseinheiten so ausgebildet, dass die zentrale Steuerungseinheit und die dezentralen Steuerungseinheiten über Lichtwellenleiter miteinander verbindbar sind. Auf diese Weise werden die nötigen Kabelverbindungen reduziert, was die Installation und die Skalierbarkeit zusätzlich vereinfacht. Bei der Verwendung von Lichtwellenleitern werden Signalstörungen aufgrund von möglichen hochfrequenten Störimpulsen vermieden.

Die oben hergeleitet Aufgabe wird insbesondere durch eine Vorrichtung zur Erzeugung elektrischer Energie, welche einen erfindungsgemäßen Leistungsschaltschrank oder eine Schaltschrankanordnung umfassend einen erfindungsgemäßen Leistungsschaltschrank aufweist, gelöst. Wie bereits ausgeführt, lässt sich durch einen erfindungsgemäßen Leistungsschaltschrank ein kostensparender, kompakter Aufbau mit minimalen Verbindungsstrecken zwischen den Komponenten und dadurch mit einem optimaler Leistungsfluss und hoher Leistungsdichte realisieren.

Dies gilt insbesondere für eine weiter ausgestaltete erfindungsgemäße Vorrichtung zur Erzeugung elektrischer Energie, welche als Windenergieanlage mit einem Generator ausgebildet ist und einen erfindungsgemäßen Leistungsschaltschrank aufweist. Als Generatoren werden wie eingangs erwähnt beispielsweise doppelt gespeiste

Asynchronmaschinen oder Synchronmaschinen verwendet. Wird eine Asynchronmaschine verwendet, ist es in der Regel ausreichend einen einzigen Leistungsschaltschrank zu verwenden, da lediglich ein Teil der Leistung über die Umrichter transportiert wird. Da Windenergieanlagen je nach Größe oder Windstärke am Einsatzort unterschiedlichste Leistungen erzeugen, müssen die verwendeten Komponenten und insbesondere die Umrichter entsprechend dieser Leistung angepasst werden können. Dies gelingt mit dem erfindungsgemäßen Leistungsschaltschrank besonders einfach und kostengünstig durch eine Anpassung von Typ und/oder Anzahl der elektronischen Leistungsschalter. Ferner ist der zu Verfügung stehende Raum bei Windenergieanlagen - beispielsweise im Inneren eines Turmes einer Windkraftanlage - meistens begrenzt, sodass der kompakte Aufbau des einzelnen Leistungsschaltschranks und damit auch einer eventuellen gesamten Schaltschrankanordnung vorteilhaft ist. Insbesondere beim Einsatz von Synchronmaschinen mit Vollumrichtern wird die gesamte elektrische Leistung über die Umrichter geführt, sodass ein kompakter und skalierbarer Aufbau bei gleichzeitig optimaler Kühlung von Vorteil ist. Einen minimalen Raumbedarf ermöglicht beispielsweise eine.Rücken an Rücken Anordnung der Leistungsschaltschränke, ohne die Zugänglichkeit und damit die Wartungsfreundlichkeit zu verschlechtern.

Im Weiteren wird die Erfindung anhand der Beschreibung von Ausführungsbeispielen in Verbindung mit der Zeichnung näher erläutert. In der Zeichnung zeigt
- Fig. 1: schematisch in Form eines Schaltplans den Aufbau eines Ausführungsbeispiels eines erfindungsgemäßen Leistungsschaltschranks,
- Fig. 2: schematisch in Form eines Blockdiagramms die Anordnung der Komponenten eines weiteren Ausführungsbeispiels eines erfindungsgemäßen Leistungsschaltschranks,
- Fig. 3: in einer perspektivischen Darstellung ein weiteres Ausführungsbeispiel eines Leistungsmoduls,
- Fig. 4: in einer perspektivischen Darstellung ein weiteres Ausführungsbeispiel eines Leistungsmoduls,
- Fig. 5: schematisch in Form eines Schaltplans den Aufbau eines Ausführungsbeispiels einer Schaltschrankanordnung einer Windenergieanlage,
- Fig. 6: in einer perspektivischen Darstellung ein weiteres Ausführungsbeispiel eines erfindungsgemäßen Leistungsschaltschranks,
- Fig. 7: in einer perspektivischen Darstellung ein weiteres Ausführungsbeispiel eines erfindungsgemäßen Leistungsschaltschranks,
- Fig. 8: verschiedene Ausführungsbeispiele einer Schaltschrankanordnung und
- Fig. 9: eine schematische Darstellung ein Ausführungsbeispiel einer Windenergieanlage mit einer Schaltschrankanordnung.

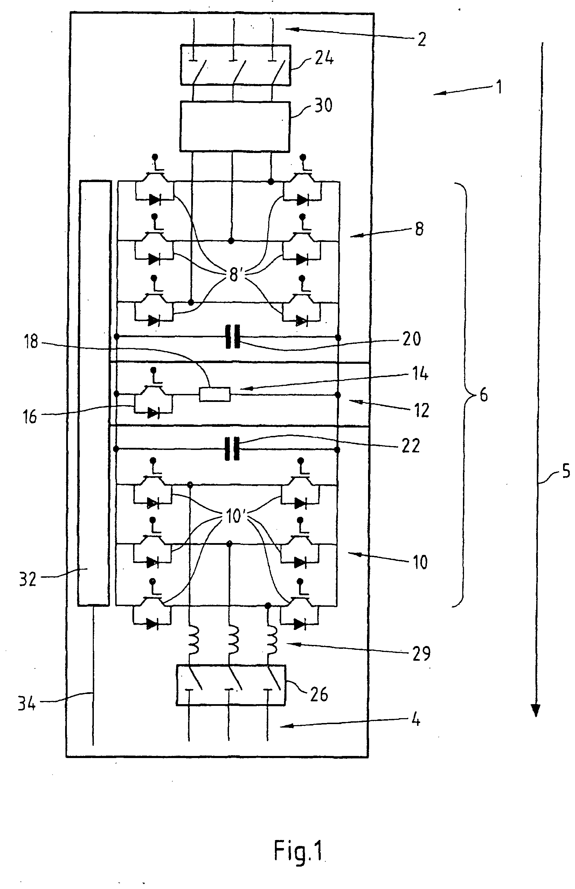

Fig. 1 zeigt schematisch in Form eines Schaltplans den Aufbau eines Ausführungsbeispiels eines Leistungsschaltschranks 1. Wie dem Schaltplan zu entnehmen ist, weist der Leistungsschaltschrank 1 an einem ersten Ende einen maschinenseitigen Anschluss 2 und an einem zweiten Ende einen netzseitigen Anschluss 4 auf. In diesem Ausführungsbeispiel sind beide Anschlüsse 2, 4 mit drei Leitern zur Bereitstellung von dreiphasigem Strom ausgelegt. Diese Anschlüsse 2, 4 können mit Kabeln oder AC-Schienen, vorzugsweise Kupferschienen, realisiert werden. Die Leistung wird hierbei vom maschinenseitigen Anschluss 2 am ersten Ende des Schaltschranks 1 in Leistungsflussrichtung, dargestellt durch den Pfeil 5, über die im Folgenden beschriebenen und in einer Reihe angeordneten Komponenten zum netzseitigen Anschluss 4 am zweiten Ende des Leistungsschaltschranks 1 in vertikaler Richtung von oben nach unter transportiert.

Über den maschinenseitigen Anschluss 2 können mehrere Schaltschränke 1 parallel geschaltet werden und mit einen Generator 68, beispielsweise einer Synchronmaschine, elektrisch leitend verbunden werden. Über den netzseitigen Anschluss 4 wird der Leistungsschaltschrank 1 elektrisch leitend mit dem Netz, beispielsweise einem Stromversorgungsnetz elektrisch verbunden. Vorzugsweise sind die mindestens zwei Leistungsschränke über die netzseitigen Anschlüsse 4 parallel geschaltet. Dabei können auch noch weitere Komponenten, wie Schalter oder Filter, insbesondere ein Netzanschlussschaltschrank 72, zwischen Netz und netzseitigem Anschluss 2 geschaltet werden.

Zwischen den Anschlüssen 2, 4 ist ein Leistungsmodul 6 angeordnet. Dieses weist einen maschinenseitigen Umrichter 8, einen netzseitigen Umrichter 10, einen Gleichspannungszwischenkreis 12 und einen Chopper 14 auf. Der Chopper 14 besteht aus einem elektronischen Leistungsschalter 16 und einem Bremswiderstand 18. Der elektronische Leistungsschalter 16 ist in diesem Fall ein IGBT. Die Umrichter 8, 10 weisen mehrere elektronische Leistungsschalter in Form von IGBTs 8', 10' auf. Es können aber auch andere elektronische Leistungsschalter verwendet werden. Der Gleichspannungszwischenkreis 12 ist über zwei Kondensatoren 20, 22 angedeutet, welche üblicherweise als Kondensatorbank 48 aus einer Vielzahl von parallel geschalteten Kondensatoren bestehen.

Der Leistungsschaltschrank 1 weist weiterhin vorzugsweise zwei Schütze 24, 26 auf, welche den Anschlüssen 2, 4 vorgeschaltet sind. Mithilfe der Schütze 24, 26 kann der gesamte Schaltschrank 1 als Einheit sowohl vom Netz als auch vom Generator 68 getrennt werden. Dies ist insbesondere für Wartungs- und Reparaturzwecke, Installationen oder bei Defekten vorteilhaft. Die Netzdrossel 29 dient der Entkopplung von Umrichter und Netz.

Zur Vermeidung von Spannungssteilheiten insbesondere am Generator ist zwischen dem maschinenseitigen Umrichter 8 und dem Schütz 24 vorzugsweise ein dU/dt-Filter 30 angeordnet. Der Leistungsschaltschrank 1 weist des Weiteren eine dezentrale Steuerungseinheit 32 auf. Diese kann mit beliebigen Komponenten des Leistungsschaltschranks 1 kommunizieren, jedoch bevorzugt mit allen Aktoren und Sensoren im Leistungsschaltschrank, beispielsweise mit den Umrichtern 8, 10 dem Chopper 14 und/oder den Schützen 24, 26. Auf diese Weise bildet der Leistungsschaltschrank 1 im Wesentlichen eine Einheit, sodass eine Schaltschrankanordnung 64, 96, 98 einfach an die Leistung eines Generators 68 durch Vorsehen einer entsprechenden Anzahl an Leistungsschaltschränken 1 angepasst werden kann. Die dezentrale Steuerungseinheit wird hier über einen, oder typischerweise zwei, Lichtwellenleiter 34 mit weiteren Steuerungseinheiten verbunden. Jedoch sind auch andere Übertragungstechniken mittels Netzwerkkabeln oder auch kabellose Übertragungsmethoden denkbar. Die dezentrale Steuerungseinheit 32 ermöglicht vor allem die Realisierung kurzer Signalwege innerhalb des Leistungsschaltschrankes selbst, so dass hier einfache elektrische Verbindungen trotz der starken elektromagnetischen Störfelder möglich werden. In jedem Fall reduziert sich die benötigte Anzahl von Kabelverbindungen zu einer zentralen Steuereinrichtung durch das Vorsehen einer dezentralen Steuerungseinheit 32 auf ein Minimum.

Grundsätzlich wird die reale Positionierung der Komponenten in einem Leistungsschaltschrank 1 zwar nicht durch die Anordnung der Komponenten eines Schaltplans festgelegt. Es ist jedoch vorgesehen, dass die Komponenten im Wesentlichen in der gleichen Reihenfolge wie im Schaltplan, also in Richtung des Leistungsflusses 5, angeordnet sind. Wie zu erkennen ist, sind die Komponenten im Wesentlichen linear in der Reihenfolge maschinenseitiger Anschluss 2, maschinenseitiger Umrichter 8, Gleichspannungszwischenkreis 12 mit Chopper 14, netzseitiger Umrichter 10 und netzseitiger Anschluss 4 angeordnet.

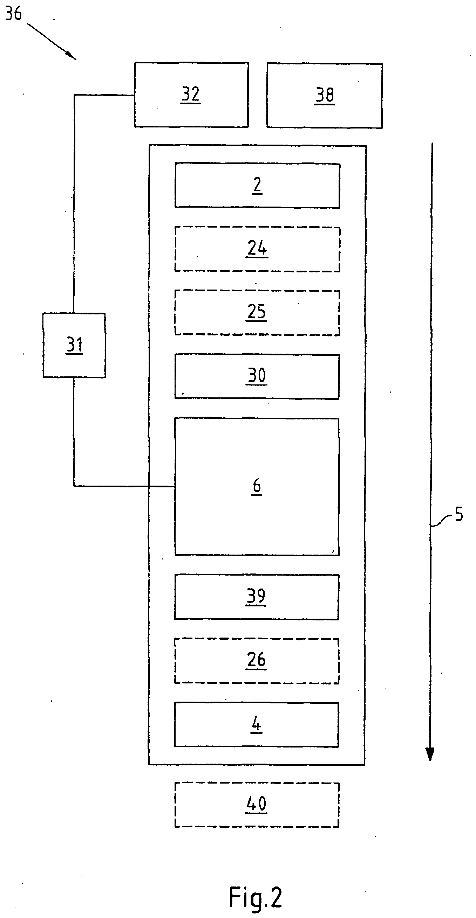

Fig. 2 zeigt schematisch in Form eines Blockdiagramms die Anordnung der Komponenten eines weiteren Ausführungsbeispiels eines Leistungsschaltschranks 36. Vor allem durch die Anordnung der Komponenten in Leistungsflussrichtung, dargestellt durch den Pfeil 5, im Wesentlichen in einer Reihe mit der Reihenfolge: maschinenseitiger Anschluss 2, optional maschinenseitiges Schütz 24, optional eine Strom- und/oder Spannungsbegrenzungsvorrichtung 25, dU/dt-Filter 30, Leistungsmodul 6, Netzdrossel 39, optional netzseitiges Schütz 26 und netzseitiger Anschluss 2 wird eine kompakte Anordnung der Komponenten bei gleichzeitig einfacher Zugänglichkeit der einzelnen Komponenten und der Möglichkeit einer ausreichenden und effektiven Kühlung erreicht. Die Anordnung kann selbstverständlich auch in umgekehrter Reihenfolge erfolgen. Eine wie gezeigt vertikale Anordnung der Komponenten in dem Leistungsschaltschrank 36 ist aufgrund der einfachen Zugänglichkeit und thermischen Effekten beim Kühlen bevorzugt. Hier kann die natürliche Konvektion die Kühlung unterstützen. Eine dezentrale Steuerungseinheit 32 sowie eine Zwischenkreisvorladeeinheit können hierbei flexibel im Leistungsschaltschrank 36 positioniert werden. Auch eine Kühlvorrichtung 38 erstreckt sich in der Regel über mehrere Komponenten im Leistungsschaltschrank 36. Es ist jedoch vorteilhaft eine Kühlung in Form eines Luft-Wasser-Wärmetauschers zwischen dem Leistungsmodul 6 und der Netzdrossel 39 vorzusehen. Vorzugsweise durch Konvektion können mittels Wasser und Luft die einzelnen Komponenten gekühlt werden. Auch ein Netzfilter 40 kann optional in dem Leistungsschaltschrank 36 vorgesehen sein. Die Strom- und/oder Spannungsbegrenzungsvorrichtung 25, welche beispielsweise als Crowbar ausgestaltet sein kann, schützt den maschinenseitigen Umrichter 8 vor einem zu hohen Strom und den Gleichspannungszwischenkreis vor einer zu hohen Spannung.

Zudem ist eine Notspannungsversorgung 31 vorgesehen, welche im Notfall die im Gleichspannungszwischenkreis 12 des Leistungsmoduls 6 gespeicherte Energie zur zeitweisen Versorgung der dezentralen Steuerungseinheit 32 verwendet, sodass benötigte Steuerungselektronik nicht ausfällt.

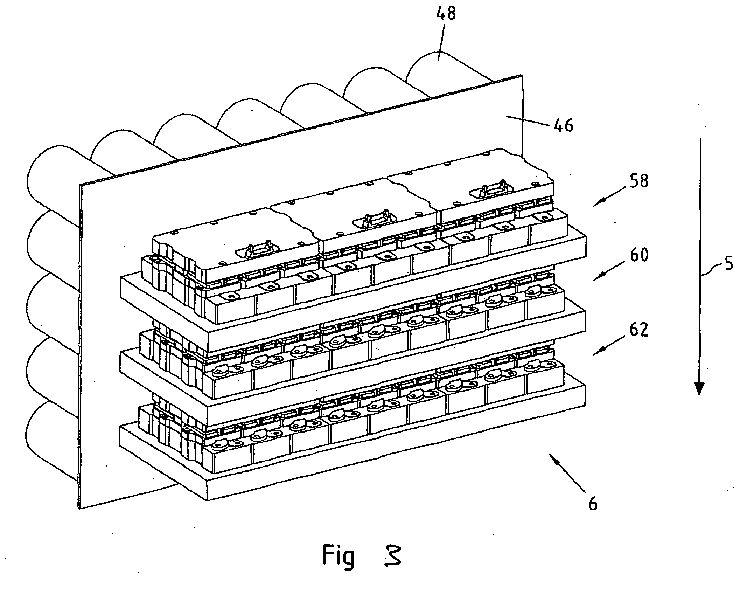

Fig. 3 zeigt in einer perspektivischen Darstellung ein weiteres Ausführungsbeispiel eines Leistungsmoduls 6. Die elektronischen Leistungsschalter 42 sind in drei Baugruppen 58, 60, 62 zusammengefasst und auf der Gleichstromverschienung 46 angeordnet. Jede dieser Baugruppen verfügt über einen Kühlkörper, vorzugsweise für Wasserkühlung. Auf der gegenüberliegenden Seite ist wiederum die Kondensatorbank 48 angeordnet. Es ist besonders bevorzugt, wenn die Baugruppen 58, 62 die elektronischen Leistungsschalter 8', 10' der Umrichter 8, 10 aufweisen, während die mittlere Baugruppe 60 den oder die elektronischen Leistungsschalter des Choppers 14 sowie optional den Widerstand 18 aufweisen. Wie leicht zu erkennen ist, können einzelne Baueinheiten 58, 60, 62 auf einfache Weise ersetzt werden, sofern diese beispielsweise defekt sind. Darüber hinaus ist eine Skalierbarkeit sehr einfach durch Hinzufügen oder Entfernen von weiteren Baueinheiten 58, 60, 62 möglich. Weist die Baugruppe 58 den maschinenseitigen Umrichter 8, die Baugruppe 62 den netzseitigen Umrichter 10 und die Baugruppe 60 den Leistungsschalter des Choppers 14 sowie den Widerstand 18 auf, ist auch im Leistungsmodul 6 die Anordnung der Komponenten in Leistungsflussrichtung, dargestellt durch den Pfeil 5, ersichtlich. Dabei erstreckt sich der elektrisch parallel geschaltete Gleichspannungszwischenkreis 12 auch parallel zu den Baugruppen 58, 60, 62.

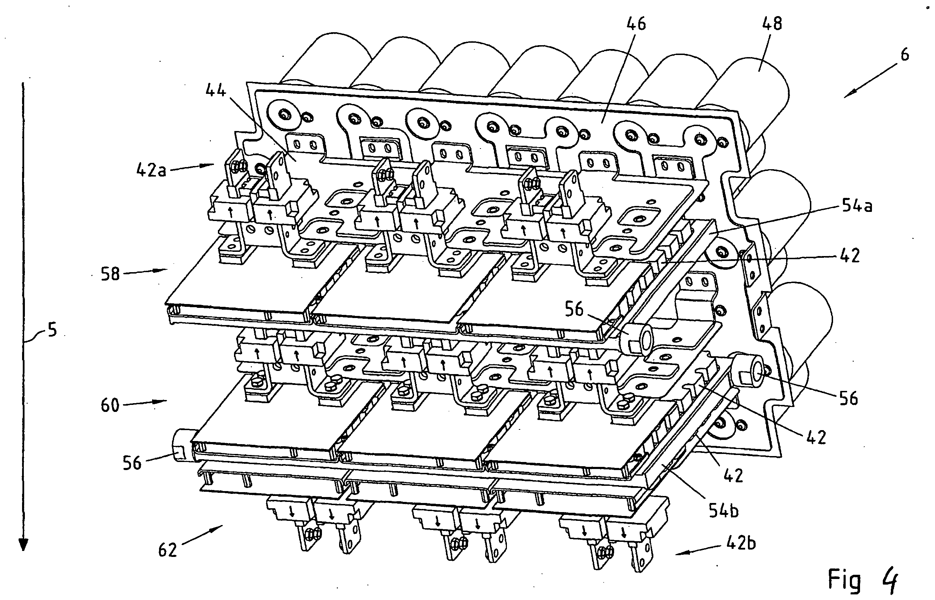

Fig. 4 zeigt ein weiteres Ausführungsbeispiel eines Leistungsmoduls 6 für einen erfindungsgemäßen Leistungsschaltschrank. Die elektronischen Leistungsschalter 42 sind ähnlich wie in Fig. 3 gezeigt wiederum in drei Baugruppen 58, 60, 62 zusammengefasst und mittels Adaptern 44 auf der Gleichstromverschienung 46 angeordnet. Durch die im Wesentlichen rechtwinkeligen Adapter, werden die plattenförmigen Leistungsschalter 42 im Wesentlichen senkrecht auf der Gleichstromverschienung 46 angeordnet. Unterhalb der Baugruppe 58 ist einen Kühlkörper 54a und zwischen den Baugruppen 60 und 62 ist einen Kühlkörper 54b angeordnet. Die Kühlkörper sind in diesem Beispiel Flüssigkeitskühlkörper mit den Anschlüssen 56. Auf der gegenüberliegenden Seite der Gleichstromverschienung ist wiederum die Kondensatorbank 48 angeordnet. Es ist besonders bevorzugt, wenn die Baugruppen 58, 62 die elektronischen Leistungsschalter 8', 10' der Umrichter 8, 10 aufweisen, während die mittlere Baugruppe 60 den oder die elektronischen Leistungsschalter des Choppers 14 sowie optional den Widerstand 18 aufweisen. Für die Kühlung des Choppers 14 wird allerdings nicht unbedingt eine Wasserkühlung benötigt, eine Kühlung mittels einer Kühlplatte, beispielsweise aus Aluminium, ist ebenfalls denkbar. Der Bremswiderstand des Choppers kann beispielsweise auch an der noch freien Unterseite der Kühlplatte 54a angeordnet werden. Ebenso können andere Bauelemente wie Widerstände des dU/dt-Filters oder Entladewiderstände an der noch freien Unterseite der Kühlplatte 54a angeordnet werden. Wie zu erkennen ist, können einzelne Baueinheiten 58, 60, 62 auf einfache Weise ersetzt werden, sofern diese beispielsweise defekt sind. Darüber hinaus ist eine Skalierbarkeit sehr einfach durch Hinzufügen oder Entfernen von weiteren Baueinheiten 58, 60, 62 möglich.

Zudem ist zu erkennen, wie die Baugruppen 58, 60, 62 des Leistungsmoduls 6 aus Fig. 4 in Richtung des Leistungsflusses, dargestellt durch den Pfeil 5, in diesem Fall in vertikaler Richtung, angeordnet sind. Die Leistungsschalter der Baugruppe 58 sind über die im Wesentlichen senkrecht zu den Leistungsmodulen ausgerichteten Anschlüsse 42a maschinenseitig verbunden, schalten die von der Maschine gelieferten Leistung und speisen diese entsprechend in den Gleichspannungszwischenkreis 12 ein. Energie kann aus dem Gleichspannungszwischenkreis 12 mittels der vertikal unterhalb der Baugruppe 58 angeordneten Leistungsschalter 42 der Baugruppe 60 entnommen werden und mittels eines Choppers 14 in Wärmeenergie umgewandelt werden. Schließlich wird die Leistung aus dem Gleichspannungszwischenkreis 12 mittels der wiederum unterhalb der Baugruppe 60 angeordneten Leistungsschalter 42 der Baugruppe 62 netzseitig über die im Wesentlichen senkrecht zu den Leistungsmodulen ausgerichteten Anschlüsse 42b abgegeben. Wie zu erkennen ist, wird ein wesentlicher Teil der Verbindungswege zwischen den einzelnen Komponenten des Leistungsmoduls 6 durch die Anordnung der einzelnen Komponenten entlang des Leistungsflusses überbrückt.

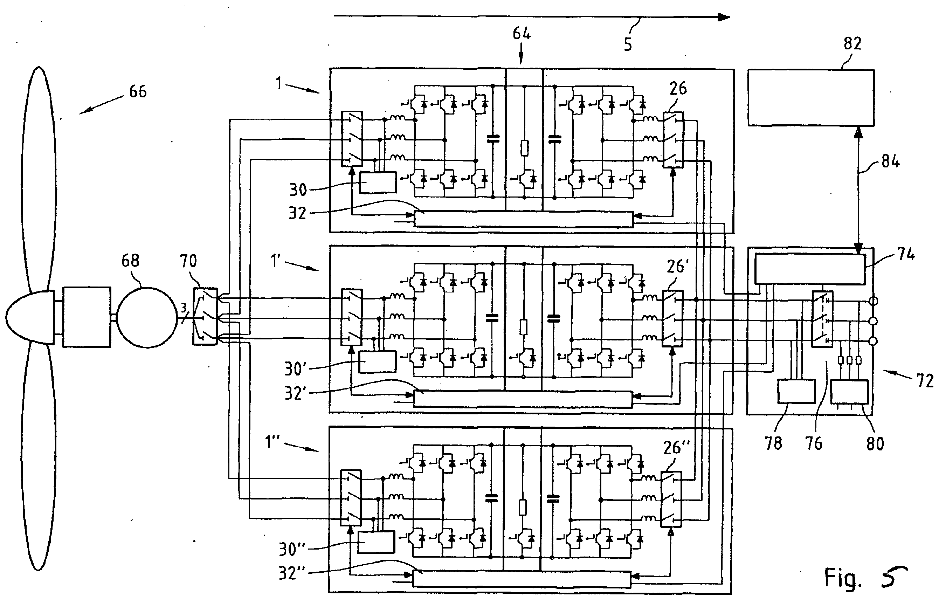

Fig. 5 zeigt schematisch in Form eines Schaltplans den Aufbau eines Ausführungsbeispiels einer Schaltschrankanordnung 64. Diese weist den Leistungsschaltschrank 1 aus Fig. 1 und zwei weitere vorzugsweise baugleiche Leistungsschaltschränke 1', 1" auf. Die Leistungsschaltschränke 1, 1', 1" sind parallel geschaltet. Es ist auch denkbar, Leistungsschaltschränke 1, 1', 1" mit unterschiedlicher Auslegung in einer Schaltschrankanordnung 64 vorzusehen, um gegebenenfalls eine bessere Leistungsanpassung zu erzielen. Auch ist denkbar, nur zwei oder mehr als drei Leistungsschaltschränke vorzusehen. Die Anordnung der Komponenten in den einzelnen Leistungsschaltschränken ist dabei, wie bereits in Fig. 1 gezeigt, jeweils in Richtung des Leistungsflusses 5 vorgesehen, sodass sich in diesem Fall drei parallele Leistungsflüsse in den drei Leistungsschaltschränken 1, 1', 1" ergeben. Durch einen Rotor 66 wird ein permanentmagneterregter Synchrongenerator 68 angetrieben. Dieser ist über einen Generatorschalter 70, welcher optional in einem Generatoranschlussschrank (nichtdargestellt) vorgesehen sein kann, mit den Leistungsschaltschränken 1, 1', 1" elektrisch leitend verbunden.

Netzseitig sind die Leistungsschaltschränke 1, 1', 1" mit einem Netzanschlussschaltschrank 72 elektrisch verbunden. Dieser weist eine zentrale Steuerungseinheit 74, einen Netzschalter 76, einen Netzfilter 78 und eine Hilfsspannungsversorgung 80 auf. Der Netzfilter 78 ist auf diese Weise allen Leistungsschaltschränke 1, 1', 1" vorgeschaltet und muss nicht separat in jeden Leistungsschaltschrank implementiert werden. Jedoch ist es möglich, den Netzfilter 78 in den Leistungsschaltschränken 1,1', 1" vorzusehen. Der Netzschalter 76, um schnell und einfach die Leistungsschaltschränke 1, 1', 1" vom Netz zu trennen, kann beispielsweise auch ein elektronischer Leistungsschalter sein. Es ist gut zu erkennen, dass abgesehen von den leitenden Verbindungen der netzseitigen Anschlüsse 26, 26', 26" mit dem Netzanschlussschaltschrank 72 lediglich eine Verbindung der dezentralen Steuerungseinheiten 32, 32', 32" mit der zentralen Steuerungseinheit 74 sowie eine nicht dargestellte Verbindung der Hilfsspannungsversorgungseinheit 80 mit den Leistungsschaltschränken 1, 1', 1" erforderlich ist. Auf diese Weise wird ein geringer Installationsaufwand und optimale Skalierbarkeit der Schaltschrankanordnung 64 erreicht. Die zentrale Steuerung 72 ist in diesem Ausführungsbeispiel mit einer Windenergieanlagensteuerung 82 über eine Datenverbindung 84 verbunden. Die Windenergieanlagensteuerung 82 kann beispielsweise Daten über den Generator 68 oder den Rotor 66 zur Verfügung stellen oder diese beeinflussen oder Leistungs- oder Stromsollwerte vorgeben. Als Datenverbindung 84 können verschiedene Schnittstellen und Busse, wie Ethernet, CANOpen oder andere digitale oder analoge Ein- und Ausgänge vorgesehen sein.

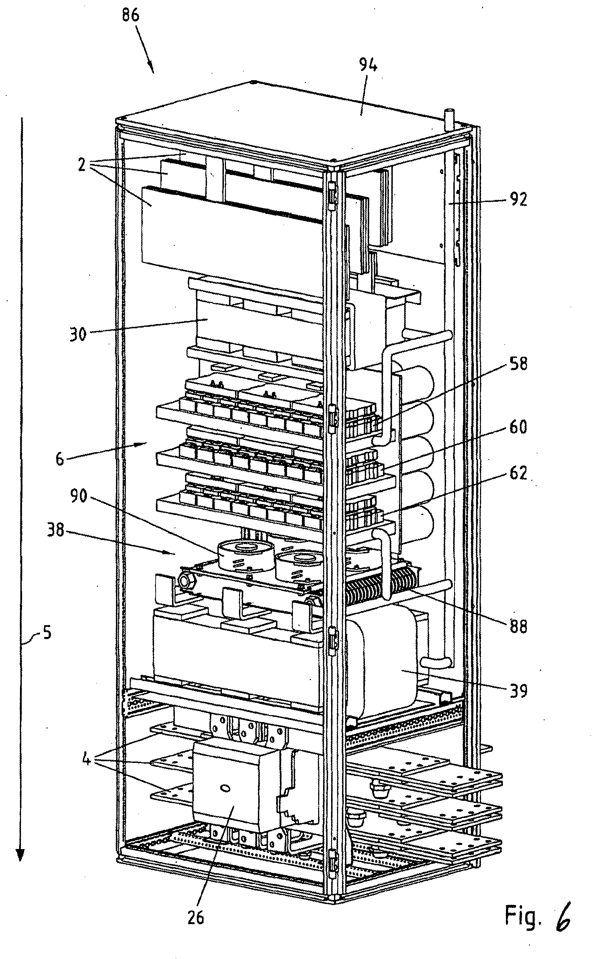

Fig. 6 zeigt in einer perspektivischen Darstellung ein weiteres Ausführungsbeispiel eines Leistungsschaltschranks 86. Der Leistungsschaltschrank 86 weist AC-Schienen als netz- und maschinenseitige Anschlüsse 2 und 4 auf. Diese sind für dreiphasigen Wechselstrom ausgelegt. Die AC-Schienen für den netzseitigen Anschluss 4 sind horizontal übereinander angeordnet, während die AC-Schienen für den maschinenseitigen Anschluss 2 vertikal hintereinander angeordnet sind. Jedoch sind andere Anordnungen ebenfalls denkbar. Ein Schütz 26 ist im Bereich des netzseitigen Anschlusses 4 angeordnet.

Oberhalb des netzseitigen Anschlusses 4 ist eine Netzdrossel 39 in den Leistungsschaltschrank 86 integriert. Hierüber ist eine Kühlvorrichtung 38 eingebaut, welche einen Luft-Wasser-Wärmetauscher 88 und einen Lüfter 90 aufweist. Insbesondere durch den Wasserkühlkreislauf 92 kann die Netzdrossel 39 gekühlt werden.

Oberhalb des Lüfters 90 ist das Leistungsmodul 6 aus Fig. 3 angeordnet. Jedoch können auch andere Ausführungsformen des Leistungsmoduls hier angeordnet sein. Durch diese Anordnung kann insbesondere die Kondensatorbank 48 des Leistungsmoduls 6 effektiv durch den Lüfter 90 gekühlt werden. Die Baugruppen 58, 60, 62 werden hierbei durch den Wasserkühlkreislauf 92 gekühlt, bzw. vor Inbetriebnahme auch optional erwärmt, um sie auf Betriebstemperatur zu bringen.

Oberhalb des Leistungsmoduls 6 ist der dU/dt-Filter 30 angeordnet, welcher ebenfalls an den Wasserkühlkreislauf 92 angeschlossen ist.

Schließlich ist oberhalb des dU/dt-Filters 30 der maschinenseitige Anschluss 2 in Form von AC-Schienen angeordnet.

Es ist gut ersichtlich, wie die einzelnen Komponenten im Leistungsschaltschrank 86 in den Rahmen 94 im Wesentlichen in einer Reihe in einer vertikalen Anordnung von oben nach unten angeordnet sind, sodass die Anordnung der Komponenten der Richtung des Leistungsflusses, dargestellt durch den Pfeil 5, entspricht. Durch die Anordnung in gegebener Reihenfolge, welche im Wesentlichen der Richtung des Leistungsflusses entspricht, können die Komponenten im Leistungsschaltschrank 86 sehr kompakt und gut zugängliche angeordnet werden, während sie gleichzeitig ausreichend gekühlt werden können.

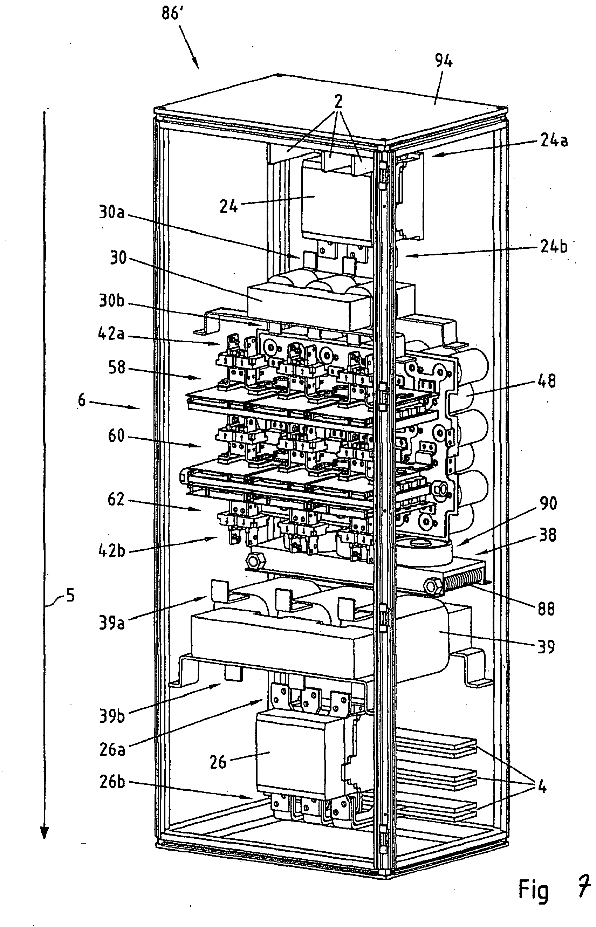

Fig. 7 zeigt in einer perspektivischen Darstellung ein weiteres Ausführungsbeispiel eines erfindungsgemäßen Leistungsschaltschranks 86' ähnlich dem Leistungsschaltschrank 86 aus Fig. 6. Der Leistungsschaltschrank 86' weist als netz- und maschinenseitige Anschlüsse 2 und 4 ebenfalls jeweils für dreiphasigen Wechselstrom ausgelegte AC-Schienen auf. Die AC-Schienen für den netzseitigen Anschluss 4 sind wiederum horizontal übereinander angeordnet, während die AC-Schienen für den maschinenseitigen Anschluss 2 vertikal nebeneinander angeordnet sind. Die AC-Schienen für den maschinenseitigen Anschluss 2 des Leistungsschaltschranks 86' verlaufen diesmal allerdings in Richtung von der Vorderseite zur Rückseite des Leistungsschaltschranks 86'. Jedoch sind andere Anordnungen ebenfalls denkbar. Ein Schütz 26 ist im Bereich des netzseitigen Anschlusses 4 angeordnet und mit dem Anschluss 26b des Schützes verbunden. Ein weitere Schütz 24 ist unterhalb der maschinenseitigen Anschlüsse 2 angeordnet und über die Anschlüsse 24a mit diesen verbunden.

Oberhalb des netzseitigen Anschlusses 4 bzw. des Schützes 26 ist wiederum eine Netzdrossel 39 in den Leistungsschaltschrank 86' integriert, welche über die Anschlüsse 39b mit dem Anschluss 26a des Schützes 26 verbunden werden kann. Über der Netzdrossel ist eine Kühlvorrichtung 38 eingebaut, welche einen Luft-Wasser-Wärmetauscher 88 und Lüfter 90 aufweist. Die Netzdrossel 39 kann hierbei wasser- oder luftgekühlt werden. Das den Luft-Wasser-Wärmetauscher 88 und die darüber angeordneten Lüfter 90 umfassende Bauteil ist im Vergleich zum Leistungsschaltschrank 86' allerdings weniger tief ausgestaltet und lediglich in der hinteren Hälfte des Leistungsschaltschranks 86' angeordnet. Oberhalb der Lüfter 90 ist das in Fig. 4 gezeigte Leistungsmodul 6 angeordnet. Die Baugruppen 58, 60, 62 werden hierbei durch den Wässerkühlkreislauf 92 gekühlt. Jedoch können auch andere Ausführungsformen des Leistungsmoduls hier angeordnet sein. Die Lüfter 90 sind weiterhin unterhalb der Kondensatoren 48 des Gleichspannungszwischenkreises angeordnet, wodurch die Kondensatorbank 48 des Leistungsmoduls 6 weiterhin effektiv durch die Lüfter 90 gekühlt werden kann. Allerdings ist im vorderen Bereich oberhalb der Netzdrossel 39 und unterhalb der netzseitigen Umrichter 42 mehr Platz für die jeweiligen Anschlüsse 39a und 42b.

Oberhalb des Leistungsmoduls 6 ist wiederum der dU/dt-Filter 30 angeordnet, welcher ebenfalls an den Wasserkühlkreislauf 92 angeschlossen werden kann. Über die Anschlüsse 42a der Umrichter des Leistungsmoduls 6 kann dieses an den dU/dt-Filter angeschlossen werden. Oberhalb des dU/dt-Filters 30 ist das maschinenseitige Schütz 24 und darüber der maschinenseitige Anschluss 2 in Form von AC-Schienen angeordnet. Der Anschluss 24b des Schützes 24 wird dabei mit dem Anschluss 30a des dU/dt-Filters 30 verbunden.

Es ist ersichtlich, wie die einzelnen Komponenten, insbesondere der maschinenseitige Anschluss 2, der dU/dt-Filter 30, das Leistungsmodul 6 (bestehend aus maschinenseitigem Umrichter 8, Gleichspannungszwischenkreis 12 und netzseitigem Umrichter 10), die Netzdrossel 39 und der netzseitige Anschluss 4, im Leistungsschaltschrank 86' in den Rahmen 94 im Wesentlichen in einer Reihe in einer vertikalen Anordnung in Richtung des Leistungsflusses, dargestellt durch den Pfeil 5, angeordnet sind. Durch die Anordnung in gegebener Reihenfolge, welche im Wesentlichen der Richtung des Leistungsflusses entspricht, können die Komponenten im Leistungsschaltschrank 86' sehr kompakt und gut zugängliche angeordnet werden, während sie gleichzeitig ausreichend gekühlt werden können.

Es ist zu erkennen, dass die einzelnen Anschlüsse der Komponenten nur einen geringen Abstand voneinander aufweisen, so beispielsweise 24b mit 30a, 30b mit 42a, 42b mit 39a und 39b mit 26a, da durch die Anordnung der Komponenten in Richtung des Leistungsflusses ein Teil des Weges im Leistungsschaltschrank 86' bereits durch die Komponenten selbst überbrückt wird.

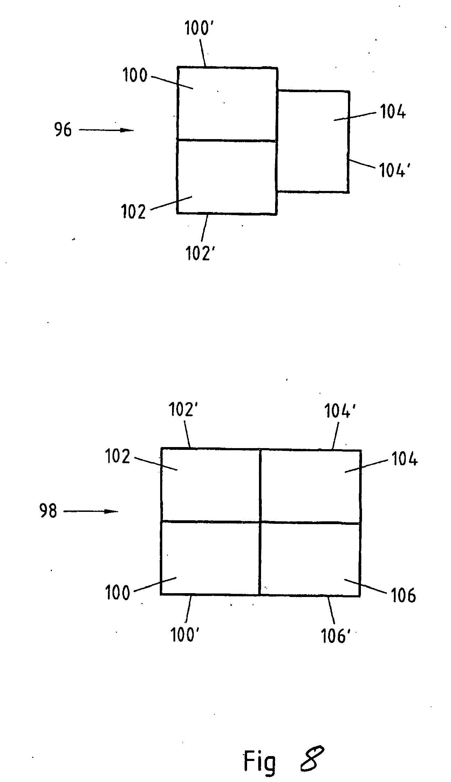

Fig. 8 zeigt verschieden Ausführungsformen einer Schaltschrankanordnung 96, 98, welche aus erfindungsgemäßen Leistungsschaltschränken bestehen kann. Die Schaltschrankanordnung 96 zeigt drei Schaltschränke 100, 102, 104 von oben. Hierbei sind die Schaltschränke 100, 102 Rücken an Rücken angeordnet, während der Schaltschrank 104 seitlich quer zu den Schältschränken 100, 102 angeordnet ist. Die Schaltschränke 100, 102, 104 sind insbesondere Leistungsschaltschränke, wobei vorzugsweise einer der Schaltschränke 100, 102, 104 auch ein Netzanschlussschaltschrank ist. Besonders vorteilhaft bei dieser Anordnung ist es, dass die AC-Schienen in den Leistungsschaltschränken 100 und 102 nur für den jeweiligen Bemessungsstrom ausgelegt sein müssen. Erst im Netzanschlussschaltschrank 104 werden die AC-Schienen zum Anschluss an das Netz zusammengeführt, so dass nur in diesem Schaltschrank die AC-Schienen für die Summe der Bemessungsströme der beiden Schaltschränke 100 und 102 ausgelegt sein müssen. Hierdurch lassen sich Kosten für Kupferverbindungen einsparen.

Die Schaltschrankanordnung 98 zeigt nun vier Schaltschränke 100, 102, 104, 106 von oben. Die Schaltschränke 100, 106 und 102, 104 sind jeweils seitlich nebeneinander angeordnet, während die Schaltschränke 100, 102 und 106, 104 jeweils Rücken an Rücken angeordnet sind. Die Schaltschränke 100, 102, 104, 106 sind insbesondere Leistungsschaltschränke, wobei vorzugsweise einer der Schaltschränke 100, 102, 104, 106 auch ein Netzanschlussschaltschrank ist.

Natürlich sind auch andere geometrische Anordnung der Schaltschränke denkbar, insbesondere seitliche Anordnungen in Reihe oder Anordnungen übereinander oder Anordnungen mit weniger als drei oder mehr als 4 Schaltschränken.

Es ist deutlich erkennbar, dass durch die Schaltschrankanordnungen 96, 98 eine platzsparende Anordnung möglich ist, wobei gleichzeitig ein einfacher Zugriff auf die Komponenten jedes Schaltschranks über die Vorderseiten 100', 102', 104', 106' möglich ist. Für die entsprechenden Anordnungen müssen lediglich die netzseitigen und maschinenseitigen Anschlüsse 2, 4 so angeordnet sein, dass die entsprechende Anordnung möglich ist.

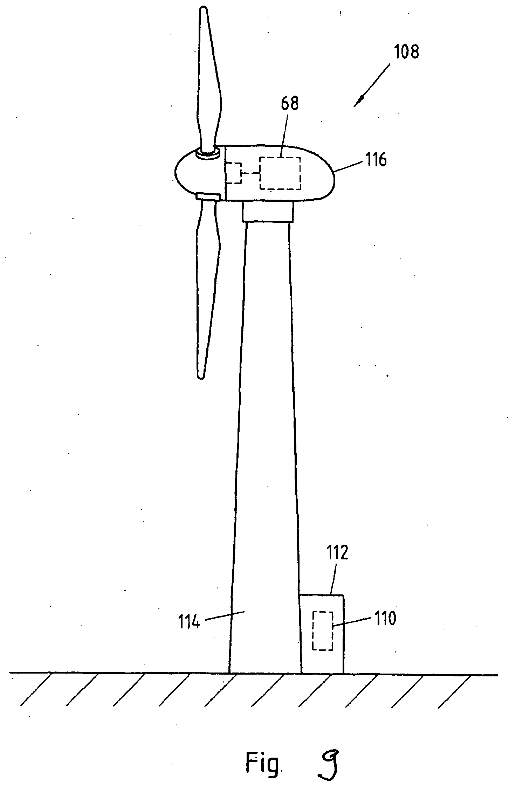

Fig. 9 zeigt nun eine schematische Darstellung einer Windenergieanlage 108 mit einer erfindungsgemäßen Schaltschrankanordnung 110. Diese kann beispielsweise so ausgebildet sein, wie die Schaltschrankanordnungen 64, 96 oder 98. Die Schaltschrankanordnung 110 ist ein einem Gehäuse 112 am Fuß der Windenergieanlage 108 montiert. Die Schaltschrankanordnung 110 kann aber auch innerhalb des Turms 114 oder in der Nähe des Generators 68, also beispielsweise in der Gondel 116 der Windenergieanlage 108, angeordnet sein. Aufgrund des geringen Platzangebots in Windenergieanlagen, insbesondere in der Gondel 116 und im Turm 114 sowie der notwendigen Anpassung der Windenergieanlagen 108 an unterschiedliche Leistungsbereiche ist die Verwendung der erfindungsgemäßen Schaltschrankanordnung 110 für Windenergieanlagen 108 besonders vorteilhaft. Allerdings kann auch lediglich ein einzelner Leistungsschaltschrank 1, 1', 1", 36, 86 oder 86' anstelle der Schaltschrankanordnung 110 vorgesehen sein. Dies ist insbesondere bei doppelt gespeisten Asynchronmaschinen, in denen nur ein Teil der Leistung über die Umrichter geführt werden muss, der Fall.

## Patentansprüche

1. Leistungsschaltschrank einer Vorrichtung zur Erzeugung elektrischer Energie wobei der Leistungsschaltschrank (1, 1', 1", 36, 86, 86')
- einen maschinenseitigen Anschluss (2),
- ein Leistungsmodul (6) und
- einen netzseitigen Anschluss (4)
aufweist, wobei das Leistungsmodul (6)
- einen maschinenseitigen Umrichter (8),
- einen netzseitigen Umrichter (10),
- einen Gleichspannungszwischenkreis (12) und
- einen Chopper (14)
aufweist und
**dadurch gekennzeichnet, dass**
die Anordnung der Komponenten (2, 4, 6, 8, 10, 12) im Wesentlichen der Richtung des Leistungsflusses entspricht, die Komponenten (2, 4, 6, 8, 10, 12) im Wesentlichen linear in der Reihenfolge
- maschinenseitiger Anschluss (2),
- maschinenseitiger Umrichter (8),
- Gleichspannungszwischenkreis (12) mit Chopper (14),
- netzseitiger Umrichter (10) und
- netzseitiger Anschluss (4),
angeordnet sind und
die Komponenten (2, 4, 6, 8, 10, 12) im Wesentlichen in vertikaler Richtung, insbesondere von oben nach unten, angeordnet sind.

2. Leistungsschaltschrank nach Anspruch 1,
**dadurch gekennzeichnet, dass**
der Leistungsschaltschrank (1, 1', 1", 36, 86, 86') weiterhin eine dezentrale Steuerungseinheit (32, 32', 32") aufweist.

3. Leistungsschaltschrank nach einem der Ansprüche 1 oder 2,
**dadurch gekennzeichnet, dass**
der Leistungsschaltschrank (1, 1', 1", 36, 86, 86') über zugeordnete Sekundärwicklungen eines oder mehrerer Transformatoren an das Netz angebunden ist.

4. Leistungsschaltschrank nach einem der Ansprüche 1 bis 3,
**dadurch gekennzeichnet, dass**
das Leistungsmodul (6) eine plattenförmige Gleichstromverschienung (46) aufweist, welche auf einer ersten Seite die Leistungsschalter und einen Chopper (8', 10', 12, 42, 58, 60, 62) aufweist und auf einer zweiten Seite die Kondensatoren (20, 22, 48) des Gleichspannungszwischenkreises (12) aufweist.

5. Leistungsschaltschrank nach einem der Ansprüche 1 bis 4,
**dadurch gekennzeichnet, dass**
der Leistungsschaltschrank (1, 1', 1", 36, 86, 86') einen dU/dt-Filter (30, 30', 30") aufweist.

6. Leistungsschaltschrank nach einem der Ansprüche 1 bis 5,
**dadurch gekennzeichnet, dass**
der Leistungsschaltschrank (1, 1', 1", 36, 86, 86') eine Netzdrossel (39) aufweist.

7. Leistungsschaltschrank nach einem der Ansprüche 1 bis 6,
**dadurch gekennzeichnet, dass**
der Leistungsschaltschrank (1, 1', 1", 36, 86, 86') an den netzseitigen Anschlüssen (4) und/oder den maschinenseitigen Anschlüssen (2) vorgeschaltete Einrichtungen zum elektrischen Trennen des Leistungsschaltschranks (24, 26, 26', 26") aufweist.

8. Leistungsschaltschrank nach einem der Ansprüche 1 bis 7,
**dadurch gekennzeichnet, dass**
der Leistungsschaltschrank (1, 1', 1", 36, 86, 86') eine Strom- und/oder Spannungsbegrenzungsvorrichtung (25) aufweist.

9. Leistungsschaltschrank nach einem der Ansprüche 1 bis 8,
**dadurch gekennzeichnet, dass**
der Leistungsschaltschrank (1, 1', 1", 36, 86, 86') eine Notspannungsversorgung (31) aufweist.

10. Leistungsschaltschrank nach einem der Ansprüche 1 bis 9,
**dadurch gekennzeichnet, dass**
der Leistungsschaltschrank (1, 1', 1", 36, 86, 86') eine Kühlvorrichtung (38), insbesondere einen Wärmetauscher (88), aufweist.

11. Leistungsschaltschrank nach Anspruch 10,
**dadurch gekennzeichnet, dass**
die Kühlvorrichtung (38) eine "Heat-Pipe" aufweist.

12. Leistungsschaltschrank nach Anspruch 10 oder 11,
**dadurch gekennzeichnet, dass**
die Kühlvorrichtung (38) zumindest einen direkt unterhalb der Kondensatoren (20, 22, 48) des Gleichspannungszwischenkreises (12) angeordneten Lüfter (90) aufweist.

13. Leistungsschaltschrank nach einem der Ansprüche 1 bis 12,
**dadurch gekennzeichnet, dass**
der Leistungsschaltschrank (1, 1', 1", 36, 86, 86') gegenüber der Umgebungsluft hermetisch geschlossen ist.

14. Vorrichtung zur Erzeugung elektrischer Energie,
**dadurch gekennzeichnet, dass**
die Vorrichtung einen Leistungsschaltschrank (1, 1', 1", 36, 86, 86') nach einem der Ansprüche 1 bis 13 aufweist.

15. Vorrichtung zur Erzeugung elektrischer Energie nach Anspruch 14,
**dadurch gekennzeichnet, dass**
die Vorrichtung als Windenergieanlage (108) mit einem Generator (68), insbesondere als Windenergieanlage eines Offshore-Windparks, ausgebildet ist.

## Claims

1. Power switch cabinet of a device for producing electric energy, wherein the power switch cabinet (1, 1', 1", 36, 86, 86') has
- a machine-side connection (2),
- a power module (6) and
- a mains-side connection (4),
wherein the power module (6) has
- a machine-side converter (8),
- a mains-side converter (10),
- a direct voltage intermediate circuit (12) and
- a chopper (14),
**characterised in that**
the arrangement of the components (2, 4, 6, 8, 10, 12) substantially corresponds to the direction of the power flow, the components (2, 4, 6, 8, 10, 12) are arranged substantially linearly in the sequence-machine-side connection (2),
- machine-side converter (8),
- direct voltage intermediate circuit (12) with chopper (14),
- mains-side converter (10) and
- mains-side connection (4),
and the components (2, 4, 6, 8, 10, 12) are arranged substantially in the vertical direction, in particular from top to bottom.

2. Power switch cabinet according to claim 1,
**characterised in that**
the power switch cabinet (1, 1', 1", 36, 86, 86') further has a decentralised control unit (32, 32', 32").

3. Power switch cabinet according to one of claims 1 or 2,
**characterized in that**
the power switch cabinet (1, 1', 1", 36, 86, 86') is connected via associated secondary windings of one or a plurality of transformers to the mains.

4. Power switch cabinet according to one of claims 1 to 3,
**characterised in that**
the power module (6) has a plate-shaped direct current busbar (46), which has on a first side the power switches and a chopper (8', 10', 12, 42, 58, 60, 62) and on a second side the capacitors (20, 22, 48) of the direct voltage intermediate circuit (12).

5. Power switch cabinet according to one of claims 1 to 4,
**characterized in that**
the power switch cabinet (1, 1', 1", 36, 86, 86') has a dU/dt filter (30, 30', 30").

6. Power switch cabinet according to one of claims 1 to 5,
**characterized in that**
the power switch cabinet (1, 1', 1", 36, 86, 86') has a line choke (39).

7. Power switch cabinet according to one of claims 1 to 6,
**characterized in that**
the power switch cabinet (1, 1', 1", 36, 86, 86'), upstream of the mains-side connections (4) and/or the machine-side connections (2), has devices for electrical isolation of the power switch cabinet (24, 26, 26', 26").

8. Power switch cabinet according to one of claims 1 to 7,
**characterized in that**
the power switch cabinet (1, 1', 1", 36, 86, 86') has a current and/or voltage limitation device (25).

9. Power switch cabinet according to one of claims 1 to 8,
**characterized in that**
the power switch cabinet (1, 1', 1", 36, 86, 86') has an emergency power supply (31).

10. Power switch cabinet according to one of claims 1 to 9,
**characterized in that**
the power switch cabinet (1, 1', 1", 36, 86, 86') has a cooling device (38), in particular a heat exchanger (88).

11. Power switch cabinet according to claim 10,
**characterized in that**
the cooling device (38) has a "heat pipe".

12. Power switch cabinet according to claim 10 or 11,
**characterised in that**
the cooling device (38) has at least one fan (90) arranged directly below the capacitors (20, 22, 48) of the direct voltage intermediate circuit (12).

13. Power switch cabinet according to one of claims 1 to 12,
**characterized in that**
the power switch cabinet (1, 1', 1", 36, 86, 86') is hermetically sealed from the ambient air.

14. Device for producing electric energy,
**characterised in that**
the device has a power switch cabinet (1, 1', 1", 36, 86, 86') according to one of claims 1 to 13.

15. Device for producing electric energy according to claim 14,
**characterized in that**
the device is designed as a wind turbine (108) with a generator (68), in particular as a wind turbine of an offshore wind farm.

## Revendications

1. Armoire électrique de puissance d'un dispositif de production d'énergie électrique, dans laquelle l'armoire électrique de puissance (1, 1', 1", 36, 86, 86') présente :
- un raccord du côté machine (2),
- un module de puissance (6) et
- un raccord du côté réseau (4),
dans laquelle le module de puissance (6) présente :
- un convertisseur du côté machine (8),
- un convertisseur du côté réseau (10),
- un circuit intermédiaire à tension continue (12) et
- un hacheur (14),
**caractérisée en ce que**
la disposition des composants (2, 4, 6, 8, 10, 12) correspond essentiellement à la direction du flux de puissance, les composants (2, 4, 6, 8, 10, 12) sont disposés essentiellement linéairement dans la séquence :
- raccord du côté machine (2),
- convertisseur du côté machine (8),
- circuit intermédiaire à tension continue (12) avec hacheur (14),
- convertisseur du côté réseau (10) et
- raccord du côté réseau (4),
et les composants (2, 4, 6, 8, 10, 12) sont disposés essentiellement dans la direction verticale, notamment du haut vers le bas.

2. Armoire électrique de puissance selon la revendication 1,
**caractérisée en ce que**
l'armoire électrique de puissance (1, 1', 1", 36, 86, 86') présente en outre une unité de commande décentralisée (32, 32', 32").

3. Armoire électrique de puissance selon l'une des revendications 1 ou 2,
**caractérisée en ce que**
l'armoire électrique de puissance (1, 1', 1", 36, 86, 86') est reliée par l'intermédiaire d'enroulements secondaires associés d'un ou plusieurs transformateurs au réseau.

4. Armoire électrique de puissance selon l'une des revendications 1 à 3,
**caractérisée en ce que**
le module de puissance (6) présente une barre conductrice à courant continu en forme de plaque (46), qui présente sur un premier côté l'interrupteur de puissance et un hacheur (8', 10', 12, 42, 58, 60, 62) et sur un deuxième côté les condensateurs (20, 22, 48) du circuit intermédiaire à tension continue (12).

5. Armoire électrique de puissance selon l'une des revendications 1 à 4,
**caractérisée en ce que**
l'armoire électrique de puissance (1, 1', 1", 36, 86, 86') présente un filtre dU/dt (30, 30', 30").

6. Armoire électrique de puissance selon l'une des revendications 1 à 5,
**caractérisée en ce que**
l'armoire électrique de puissance (1, 1', 1", 36, 86, 86') présente une inductance réseau (39).

7. Armoire électrique de puissance selon l'une des revendications 1 à 6,
**caractérisée en ce que**
l'armoire électrique de puissance (1, 1', 1", 36, 86, 86') présente sur les raccords du côté réseau (4) et/ou sur les raccords du côté machine (2) des dispositifs branchés en amont de séparation électrique de l'armoire électrique de puissance (24, 26, 26', 26") .

8. Armoire électrique de puissance selon l'une des revendications 1 à 7,
**caractérisée en ce que**
l'armoire électrique de puissance (1, 1', 1", 36, 86, 86') présente un dispositif de limitation de courant et/ou de tension (25).

9. Armoire électrique de puissance selon l'une des revendications 1 à 8,
**caractérisée en ce que**
l'armoire électrique de puissance (1, 1', 1", 36, 86, 86') présente une alimentation en tension de secours (31) .

10. Armoire électrique de puissance selon l'une des revendications 1 à 9,
**caractérisée en ce que**
l'armoire électrique de puissance (1, 1', 1", 36, 86, 86') présente un dispositif de refroidissement (38), notamment un échangeur thermique (88).

11. Armoire électrique de puissance selon la revendication 10,
**caractérisée en ce que**
le dispositif de refroidissement (38) présente un "caloduc".

12. Armoire électrique de puissance selon la revendication 10 ou 11,
**caractérisée en ce que**
le dispositif de refroidissement (38) présente au moins un ventilateur (90) disposé directement en dessous des condensateurs (20, 22, 48) du circuit intermédiaire à tension continue (12).

13. Armoire électrique de puissance selon l'une des revendications 1 à 12,
**caractérisée en ce que**
l'armoire électrique de puissance (1, 1', 1", 36, 86, 86') est fermée hermétiquement par rapport à l'air ambiant.

14. Dispositif de production d'énergie électrique,
**caractérisé en ce que**
le dispositif présente une armoire électrique de puissance (1, 1', 1", 36, 86, 86') selon l'une des revendications 1 à 13.

15. Dispositif de production d'énergie électrique selon la revendication 14,
**caractérisé en ce que**
le dispositif est conçu comme une éolienne (108) avec un générateur (68), notamment comme une éolienne d'un parc éolien offshore.
